# EUROPEAN PATENT APPLICATION

(11) **EP 4 567 809 A1**
(43) Date of publication of application: **11.06.2025**
(21) Application number: 24217885.3
(22) Date of filing: 05.12.2024
(51) Int. Cl.: G11C 11/406

(54) **MEMORY DEVICE SUPPORTING EXTENDED ROW HAMMER REFRESH OPERATION AND OPERATION METHOD THEREOF**

(30) Priority: 06.12.2023 KR 20230176033; 23.05.2024 KR 20240067140
(71) Applicant: Samsung Electronics Co., Ltd., Suwon-si, Gyeonggi-do 16677 (KR)
(72) Inventor: SHIN, Hoon, 16677 Suwon-si (KR); SHIN, Minchur, 16677 Suwon-si (KR); KIM, Ki-Heung, 16677 Suwon-si (KR); SEOL, Hoseok, 16677 Suwon-si (KR)
(74) Representative: Marks & Clerk LLP

(57) **Abstract**

A memory device includes a bank including memory cells. The bank includes rows arranged in a row direction, count cells, each storing row hammer count data associated with a number of times a corresponding row of the rows is accessed, and extended count cells, each storing information about one or more of extended row hammer count data associated with the number of times the corresponding row of the row is accessed or a number of times a row hammer refresh operation is executed on the corresponding row of rows.

## Description

### BACKGROUND

The present disclosure relates to a memory device and an operation method thereof.

A memory device is used to store data and is classified as a volatile memory device or a nonvolatile memory device. The volatile memory device refers to a memory device which loses data stored therein when a power is turned off. As the volatile memory device, a dynamic random access memory (DRAM) is used in various fields such as a mobile system, a server, and a graphics device.

A row hammer refers to a phenomenon in which, when a row (e.g., an aggressor row) of a dynamic random access memory (DRAM) is frequently accessed, data of a row(s) (e.g., a victim row(s)) physically adjacent to the corresponding row change. The row hammer issue may be solved by performing a row hammer refresh operation on risky rows at an appropriate time.

When a specific word line is accessed aggressively, the row hammer phenomenon that data stored in memory cells connected to a word line closest to the corresponding word line are lost may occur.

### SUMMARY

It is an aspect to provide a memory device capable of preventing a row hammer phenomenon effectively.

According to an aspect of one or more embodiments, there is provided a memory device comprising at least one bank including a plurality of memory cells, wherein the at least one bank includes a plurality of rows arranged in a row direction; a plurality of count cells, each configured to store row hammer count data associated with a number of times a corresponding row of the plurality of rows is accessed; and a plurality of extended count cells, each configured to store information about at least one of extended row hammer count data associated with the number of times the corresponding row of the plurality of rows is accessed or a number of times a row hammer refresh operation is executed on the corresponding row of the plurality of rows.

According to another aspect of one or more embodiments, there is provided an operation method of a memory device, the operation method comprising managing at least one of row hammer count data of each of a plurality of rows, extended row hammer count data of each of the plurality of rows, or a number of times a row refresh operation is executed for each of the plurality of rows, using count cells and extended count cells of a count cell area of a bank; managing, using a register, at least one of the row hammer count data, the extended row hammer count data, or the number of times the row refresh operation is executed, for at least one row among the plurality of rows; and performing a row hammer refresh operation on a victim row or performing an extended row hammer refresh operation on an extended victim row, based on information on the row hammer count data, the extended row hammer count data, or the number of times the row refresh operation is executed that is included in the register.

According to another aspect of one or more embodiments, there is provided a memory device comprising at least one bank each including a plurality of memory cells; and a register corresponding to the at least one bank, wherein the at least one bank includes a plurality of rows arranged in a row direction; a plurality of count cells, each configured to store row hammer count data associated with a number of times a corresponding row of the plurality of rows is accessed; and a plurality of extended count cells, each configured to store information about at least one of the number of times the corresponding row is accessed or a number of times a row hammer refresh operation is executed on the corresponding row, wherein the register stores information about at least one of row hammer count data of at least one row among the plurality of rows, extended row hammer count data of the at least one row, or the number of times a row hammer refresh operation is executed on the at least one row.

At least some of the above and other features of the invention are set out in the claims.

### BRIEF DESCRIPTION OF THE FIGURES

The above and other aspects will become apparent by describing in detail embodiments thereof with reference to the accompanying drawings, in which:
FIG. 1A is a block diagram illustrating an example of a memory system according to an embodiment;
FIG. 1B is a block diagram illustrating another example of a memory system according to an embodiment;
FIG. 2 is a flowchart for describing an operation of a memory device according to an embodiment;
FIG. 3A is a flowchart for describing an operation of a memory device according to an embodiment;
FIG. 3B is a flowchart for describing an operation of a memory device according to an embodiment;
FIG. 4 is a block diagram illustrating another example of a memory system according to an embodiment;
FIG. 5 is a diagram illustrating an example of a bank according to an embodiment;
FIG. 6A is a conceptual diagram for describing a configuration of a bank which includes a count cell area (CCA) implemented to include count cells and extended count cells, according to an embodiment;
FIG. 6B is a conceptual diagram for describing a configuration of a bank which includes a count cell area (CCA) implemented to include count cells and flag cells, according to an embodiment;
FIG. 6C is a conceptual diagram for describing a configuration of a bank which includes a count cell area (CCA) implemented to include count cells, extended count cells, and parity cells, according to an embodiment;
FIGS. 7A and 7B are diagrams for describing a row hammer (RH) register which manages an address and RH count data of a row, according to an embodiment;
FIGS. 7C and 7D are diagrams for describing an extended row hammer (ERH) register which manages an address and ERH count data of a row, according to an embodiment;
FIGS. 7E and 7F are diagrams for describing a register which manages an address and ERH flag data of a row, according to an embodiment;
FIG. 8 is a block diagram illustrating an example of a memory device according to an embodiment;
FIG. 9 is a diagram illustrating an example of a bank array according to an embodiment;
FIG. 10 is a diagram for describing an example of an operation of a memory device which manages RH count data through a count cell of a count cell area, according to an embodiment;
FIG. 11 is a flowchart for describing an example of an operation of a memory device which manages relatively large RH count data by using an RH register, according to an embodiment;
FIG. 12 is a flowchart for describing an example of an operation of a memory device which performs a row hammer refresh operation based on information of a row managed in a RH register, according to an embodiment;
FIGS. 13 and 14 are diagrams for describing an example of an operation of a memory device which manages ERH count data through an extended count cell, according to an embodiment;
FIGS. 15 and 16 are diagrams for describing another example of an operation of a memory device which manages ERH count data through an extended count cell, according to an embodiment;
FIGS. 17, 18A, and 18B are diagrams for describing an example of an operation of a memory device which manages relatively large ERH count data by using an ERH register, according to an embodiment;
FIGS. 19 and 20 are diagrams for describing another example of an operation of a memory device which manages relatively large ERH count data by using an ERH count data register, according to an embodiment;
FIGS. 21 and 22 are diagrams for describing another example of an operation of a memory device which manages relatively large ERH count data by using an ERH register, according to an embodiment;
FIGS. 23 and 24 are diagrams for describing another example of an operation of a memory device which manages relatively large ERH count data by using an ERH register, according to an embodiment;
FIGS. 25, 26A, and 26B are diagrams for describing an example of an operation of a memory device which performs an extended row hammer refresh operation based on information of a row managed in an ERH count data register, according to an embodiment;
FIGS. 27 and 28 are diagrams for describing another example of an operation of a memory device which performs an extended row hammer refresh operation based on information of a row managed in an ERH register, according to an embodiment;
FIG. 29 is a flowchart for describing an example of an operation of a memory device which selectively performs a row hammer refresh operation and an extended row hammer refresh operation, according to an embodiment;
FIG. 30 is a flowchart for describing another example of an operation of a memory device which selectively performs a row hammer refresh operation and an extended row hammer refresh operation, according to an embodiment;
FIGS. 31, 32A, and 33B are diagrams for describing an example of an operation of a memory device which performs an extended row hammer refresh operation by using ERH flag data, according to an embodiment;
FIGS. 33 and 34 are diagrams for describing another example of an operation of a memory device which performs an extended row hammer refresh operation by using ERH flag data, according to an embodiment;
FIGS. 35 and 36 are diagrams for describing another example of an operation of a memory device which performs an extended row hammer refresh operation by using ERH flag data, according to an embodiment;
FIG. 37 is a flowchart for describing another example of an operation of a memory device which performs an extended row hammer refresh operation by using flag data, according to an embodiment;
FIGS. 38A, 38B, and 38C are diagrams illustrating various embodiments, in which ERH flag data are set.

### DETAILED DESCRIPTION

Below, various embodiments will be described in detail and clearly to such an extent that an ordinary one in the art may easily carry out the various embodiments. As used in this specification, the phrase of a form "at least one of A, B, or C" includes within its scope "only A", "only B", "only C", "A and B", "A and C", "B and C", and "A, B, and C."

### [Memory Device Supporting Row Hammer Refresh Operation and/or Extended Row Hammer Refresh Operation]

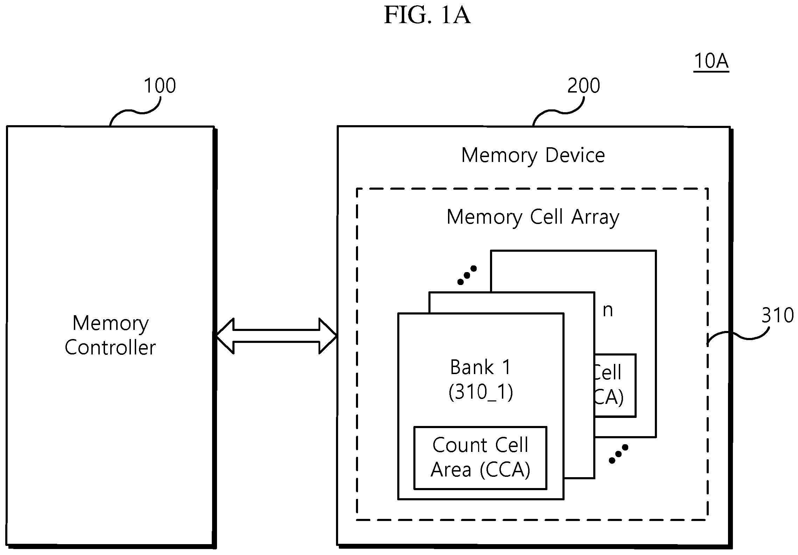

FIG. 1A is a block diagram illustrating an example of a memory system according to an embodiment. As illustrated in FIG. 1A, a memory system 10A may include a memory controller 100 and a memory device 200.

The memory device 200 according to according to an embodiment may support a row hammer refresh operation and/or an extended row hammer refresh operation.

In an embodiment, the row hammer refresh operation may refer to a refresh operation for preventing the row hammer phenomenon from occurring on at least one row closest to an aggressor row. At least one row closest to an aggressor row may be referred to as a "victim row", and the phenomenon that data stored in memory cells connected to the victim row are lost may be referred to as a "row hammer phenomenon".

The extended row hammer refresh operation may refer to a refresh operation for preventing the row hammer phenomenon from occurring on at least one row adjacent to an aggressor row. For example, at least one row adjacent to an aggressor row may be referred to as an "extended victim row", and the extended victim row may be disposed adjacent to the aggressor row with the victim row interposed therebetween. The phenomenon that data stored in memory cells connected to the extended victim row are lost may be referred to as an "extended row hammer phenomenon".

To support the row hammer refresh operation and/or the extended row hammer refresh operation, the memory device 200 according to according to an embodiment may include a plurality of count cells and/or extended count cells respectively corresponding to a plurality of rows. Each count cell may store count data indicating the number of times of access of the corresponding row. Each extended cell may store count data indicating the number of times of access of the corresponding row, or flag data being the number of times of execution of the row hammer refresh operation on the corresponding row. As the memory device 200 supports the row hammer refresh operation and/or the extended row hammer refresh operation, the memory device 200 may effectively prevent the row hammer phenomenon and/or the extended row hammer phenomenon.

Below, the description will be given in detail with reference to FIG. 1A. Referring to FIG. 1A, the memory system 10A may include a memory controller 100 and the memory device 200.

The memory controller 100 may control the memory device 200. For example, the memory controller 100 may control the memory device 200 depending on a request of a processor supporting various applications such as a server application, a personal computer (PC) application, and/or a mobile application. For example, the memory controller 100 may include a processor and may control the memory device 200 depending on a request of the processor.

To control the memory device 200, the memory controller 100 may transmit a command and/or an address to the memory device 200. Also, the memory controller 100 may transmit data to the memory device 200 or may receive data from the memory device 200.

The memory device 200 may receive data from the memory controller 100 and may store the received data. In response to a request of the memory controller 100, the memory device 200 may read the stored data and may transmit the read data to the memory controller 100.

In an embodiment, the memory device 200 may be a memory device including volatile memory cells. For example, the memory device 200 may include various dynamic random access memory (DRAM) devices such as a double data rate synchronous DRAM (DDR SDRAM), a DDR2 SDRAM, a DDR3 SDRAM, a DDR4 SDRAM, a DDR5 SDRAM, a DDR6 SDRAM, a low power double data rate (LPDDR) SDRAM, an LPDDR2 SDRAM, an LPDDR3 SDRAM, an LPDDR4 SDRAM, an LPDDR4X SDRAM, an LPDDR5 SDRAM, an LPDDR6 SDRAM, a graphics double data rate synchronous graphics random access memory (GDDR SGRAM), a GDDR2 SGRAM, a GDDR3 SGRAM, a GDDR4 SGRAM, a GDDR5 SGRAM, and/or a GDDR6 SGRAM.

In an embodiment, the memory device 200 may be a stacked memory device, in which DRAM dies are stacked, such as a high bandwidth memory (HBM), an HBM2, or an HBM3.

In an embodiment, the memory device 200 may be a memory module such as a dual in-line memory module (DIMM). For example, the memory device 200 may be a registered DIMM (RDIMM), a load reduced DIMM (LRDIMM), an unbuffered DIMM (UDIMM), a fully buffered DIMM (FB-DIMM), or a small outline DIMM (SO-DIMM). However, these are provided as an example and, in some embodiments, the memory device 200 may be any other memory module such as a single in-line memory module (SIMM).

In an embodiment, the memory device 200 may be an SRAM device, a NAND flash memory device, a NOR flash memory device, an RRAM device, an FRAM device, a PRAM device, a TRAM device, an MRAM device, etc.

The memory device 200 may include a memory cell array 310.

The memory cell array 310 may include a plurality of banks 310_1 to 310_n, each of which includes memory cells for storing data. For convenience of description, in this specification, it is assumed that each bank includes DRAM cells. However, this is provided as an example and, in some embodiments, each of the plurality of banks 310_1 to 310_n may be implemented to include any other volatile memory cells except for the DRAM cells. In some embodiments, the plurality of banks 310_1 to 310_n may be implemented to include the same kind of memory cells or may be implemented to include different kinds of memory cells.

Each of the plurality of banks 310_1 to 310_n may include a plurality of rows. In an embodiment, the row may refer to a conductive line which is disposed to extend in a row direction and is electrically connected to memory cells. For example, one row may refer to one word line disposed to extend in the row direction. However, this is provided as an example. According to an embodiment, one row may refer to a plurality of word lines disposed to extend in the row direction.

Each of the plurality of banks 310_1 to 310_n may include a count cell area CCA.

In an embodiment, the count cell area CCA may include a plurality of count cells for the row hammer refresh operation. For example, some of memory cells connected to one row may be allocated for count cells. The plurality of count cells may respectively correspond to the plurality of rows and may store the number of times of access of the corresponding row as count data. In other words, in an embodiment, a first count cell may store the number of times of access of a first row as count data for the first row, a second count cell may store the number of times of access of a second row as count data for the second row, and so on. The count data stored in each of the plurality of count cells may be referred, for example, to as "row hammer (RH) count data".

For example, when a target row is accessed, RH count data may be read from a count cell corresponding to the target row being in an active state. Afterwards, the read RH count data may be modified, and the modified RH count data may be again written in the count cell corresponding to the target row. The number of times of access of each of the plurality of rows may be stored in the corresponding count cell through a read-modify-write (RMW) operation. The RH count data stored in the count cell may be reset, for example, when the row hammer refresh operation on the corresponding row is performed.

In an embodiment, the count cell area CCA may include extended count cells for the extended row hammer refresh operation. For example, some of memory cells connected to one row may be allocated for extended count cells. The plurality of extended count cells may respectively correspond to the plurality of rows.

According to an embodiment, each extended count cell may store the number of times of access of the corresponding row as count data. In other words, in an embodiment, a first extended count cell may store the number of times of access of a first row as count data for the first row, a second extended count cell may store the number of times of access of a second row as count data for the second row, and so on. The count data stored in each of the plurality of extended count cells may be referred, for example, to as "extended row hammer (ERH) count data".

For example, when a target row is accessed, ERH count data may be read from a count cell corresponding to the target row being in an active state. Afterwards, the read ERH count data may be modified, and the modified ERH count data may be again written in the extended cell corresponding to the target row. The number of times of access of each of the plurality of rows may be stored in the corresponding extended cell through the read-modify-write operation. The ERH count data stored in the extended cell may be reset, for example, when the extended row hammer refresh operation on the corresponding row is performed. In other words, RH count data stored in a count cell and ERH count data stored in an extended cell may be managed independently of each other and may be reset at different time points.

In some embodiments, each extended cell may store the number of times of execution of the row hammer refresh operation on the corresponding row as flag data. The flag data stored in each of the plurality of extended count cells may be referred, for example, to as "extended row hammer (ERH) flag data".

For example, any one row may be designated as a management aggressor row, and the row hammer refresh operation on at least one victim row closest to the corresponding management aggressor row may be performed. In this case, flag data associated with the corresponding management aggressor row may be updated. Afterwards, the updated flag data may be again stored in the corresponding extended cell.

In an embodiment, some of memory cells connected to one row may be used as a count cell, and others of the memory cells connected to the one row may be used as an extended count cell. In this case, the count cell area CCA may include a count cell and an extended count cell for each of the plurality of rows.

In some embodiments, some of memory cells connected to one row may be used as a count cell, others of the memory cells connected to the one row may be used as an extended count cell, and still others of the memory cells connected to the one row may be used as a parity cell. A parity cell may store parity data for performing an error correction operation on count data. In this case, the count cell area CCA may include count cells, extended count cells, and parity cells for the plurality of rows.

Meanwhile, in FIG. 1A, the description is given in which each of the plurality of banks 310_1 to 310_n includes the count cell area CCA. However, this is provided as an example. According to an embodiment, some of the plurality of banks 310_1 to 310_n may omit the count cell area CCA. In some embodiments, different banks may share the same count cell area CCA. For example, in an embodiment, when different banks share the same word line, only one bank among the different banks may include the count cell area CCA, and the remaining banks of the different banks may share and use the corresponding count cell area CCA.

As described above, the memory device 200 may support the row hammer refresh operation and/or the extended row hammer refresh operation. To this end, the memory device 200 may include a plurality of count cells and/or a plurality of extended count cells for the plurality of rows. Since the memory device 200 supports the row hammer refresh operation and/or the extended row hammer refresh operation, the memory device 200 may effectively prevent the row hammer phenomenon and/or the extended row hammer phenomenon.

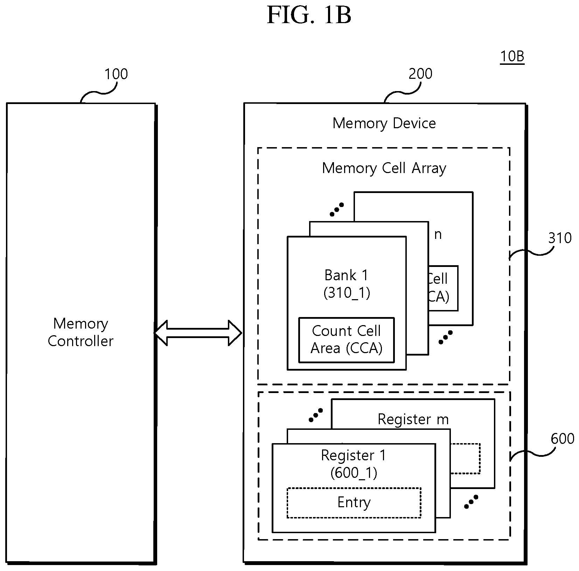

FIG. 1B is a block diagram illustrating an example of a memory system according to an embodiment. A memory system 10B of FIG. 1B is similar to the memory system 10A of FIG. 1A. Thus, the same or similar components may be marked by the same or similar reference numerals/signs, and additional description associated with the same or similar components will be omitted to avoid redundancy.

Referring to FIG. 1B, the memory system 10B may include the memory controller 100 and the memory device 200. Unlike the memory system 10A of FIG. 1A, the memory device 200 of the memory system 10B may further include a register group 600.

The register group 600 may include a plurality of registers 600_1 to 600_m. In an embodiment, one register may correspond to one bank. In some embodiments, one register may correspond to a plurality of banks.

In an embodiment, some of the plurality of registers 600_1 to 600_m may be used for the row hammer refresh operation. A register, which is used for the row hammer refresh operation, from among the plurality of registers 600_1 to 600_m may be referred to as a "row hammer (RH) register".

For example, the RH register may store information about some of a plurality of rows included in the corresponding bank. For example, the RH register may store an address and RH count data, which are associated with a row having relatively large RH count data from among the plurality of rows included in the corresponding bank. An address and RH count data of one row managed in the RH register may be referred to as an "entry".

In this case, the RH register may be updated based on a comparison result of an address and RH count data of a target row and the address and the RH count data managed in the RH register.

For example, the RH register may include a plurality of entries. In this case, when at least one of RH count data of the entries of the RH register is less than the RH count data of the target row, an entry of the register, which corresponds to the minimum RH count data, may be replaced with the address and the RH count data of the target row. In other words, when at least one of RH count of the entries of the RH register is less than the RH count of the target row, an entry of the register, which corresponds to the minimum RH count, may be replaced with the address and the RH count of the target row

For example, the RH register may include one entry. In this case, when RH count data of the entry of the register is less than the RH count data of the target row, the entry of the RH register may be replaced with the address and the RH count data of the target row.

For example, an address of the entry of the RH register may coincide with the address of the target row. In this case, previous RH count data of an entry corresponding to the target row from among the entries of the RH register may be updated to be changed to newly modified RH count data of the target row.

As described above, the memory device 200 may manage an address and RH count data associated with a row having relatively large RH count data from among a plurality of rows of a bank in the RH register, based on a comparison result of an address and/or RH count information of a target row and an address and/or RH count information of a row managed in the RH register. The RH register may be used to perform the row hammer refresh operation, and thus, the risk of occurrence of the row hammer phenomenon may be managed to be an appropriate level or lower.

In an embodiment, some of the plurality of registers 600_1 to 600_m may be used for the extended row hammer refresh operation. A register, which is used for the extended row hammer refresh operation, from among the plurality of registers 600_1 to 600_m may be referred to as an "extended row hammer (ERH) register". For example, the ERH register may store information about some of a plurality of rows included in the corresponding bank. For example, the ERH register may store an address and ERH count data, which are associated with a row having relatively large ERH count data from among the plurality of rows included in the corresponding bank. An address and ERH count data of one row managed in the ERH register may be referred to as an "entry".

In this case, the ERH register may be updated based on a comparison result of an address and ERH count data of a target row and the address and the ERH count data managed in the ERH register.

For example, the ERH register may include a plurality of entries. In this case, when at least one of ERH count data of the entries of the ERH register is less than the ERH count data of the target row, an entry, which corresponds to the minimum ERH count data, from among entries of the ERH register may be replaced with the address and the ERH count data of the target row.

For example, the ERH register may include one entry. In this case, when ERH count data of the entry of the register is less than the ERH count data of the target row, the entry of the ERH register may be replaced with the address and the ERH count data of the target row.

For example, an address of the entry of the ERH register may coincide with the address of the target row. In this case, previous ERH count data of an entry corresponding to the target row from among the entries of the ERH register may be updated to be changed to newly modified ERH count data of the target row.

As described above, the memory device 200 may manage an address and ERH count data associated with a row having relatively large ERH count data from among a plurality of rows of a bank in the ERH register, based on a comparison result of an address and/or ERH count information of a target row and an address and/or ERH count information of a row managed in the ERH register. The ERH register may be used to perform the extended row hammer refresh operation, and thus, the risk of occurrence of the extended row hammer refresh operation may be managed to be an appropriate level or lower.

In an embodiment, some of the plurality of registers 600_1 to 600_m may be used for the row hammer refresh operation and the extended row hammer refresh operation. For example, some of the plurality of registers 600_1 to 600_m may store an address and RH count data for the row hammer refresh operation and ERH flag data for the extended row hammer refresh operation.

For example, in an embodiment, the ERH flag data for the extended row hammer refresh operation may be additionally managed in the RH register. In this case, each of entries of the RH register may include a row address, RH count data corresponding to the row address, and ERH flag data corresponding to the row address. The RH count data of the RH register may correspond to the number of times of access of the corresponding row. The ERH flag data of the RH register may correspond to the number of times of execution of the row hammer refresh operation on the corresponding row.

As described above, the memory device 200 may manage information used to perform the row hammer refresh operation and information used to perform the extended row hammer refresh operation through one register, for each row.

Accordingly, the register may be used to perform the row hammer refresh operation and the extended row hammer refresh operation, and thus, both the risk of occurrence of the row hammer phenomenon and the risk of occurrence of the extended row hammer phenomenon may be managed to be an appropriate level or lower. In addition, since the memory device 200 manages the number of times of execution of the row hammer refresh operation for each row through the ERH flag data, the memory device 200 may easily set an execution ratio of the row hammer refresh operation to the extended row hammer refresh operation for each row.

The memory device 200 may perform the row hammer refresh operation and/or the extended row hammer refresh operation at various opportunities. For example, in an embodiment, the memory device 200 may perform the row hammer refresh operation and/or the extended row hammer refresh operation in response to a refresh management (RFM) command received from the memory controller 100. In some embodiments, when a normal refresh operation is performed, the memory device 200 may perform the row hammer refresh operation and/or the extended row hammer refresh operation together. In some embodiments, when the memory device 200 is in an idle state or the background operation is performed, the memory device 200 may perform the row hammer refresh operation and/or the extended row hammer refresh operation.

In an embodiment, the memory device 200 may perform the row hammer refresh operation based on information about a row managed in the RH register. For example, the memory device 200 may designate a row having the maximum RH count data from among rows managed in the RH register as a management aggressor row and may perform the refresh operation on a victim row adjacent to the management aggressor row. For example, the victim row may be at least one row closest to the management aggressor row. However, this is provided as an example. According to an embodiment, the memory device 200 may designate a plurality of rows having relatively large RH count data from among the rows managed in the RH register as a management aggressor row.

Accordingly, the row hammer refresh operation may be performed in association with a row having the maximum RH count data from among rows accessed during a given time from a current time point. As a result, the memory device 200 may manage the risk of occurrence of the row hammer phenomenon for each row to be an appropriate level or lower. This structural configuration and operation may mean that the row hammer phenomenon is effectively prevented.

In an embodiment, the memory device 200 may perform the extended row hammer refresh operation based on information about a row managed in the ERH register. For example, the memory device 200 may designate a row having the maximum ERH count data from among rows managed in the ERH register as a management aggressor row and may perform the refresh operation on an extended victim row adjacent to the management aggressor row. For example, the extended victim row may be at least row adjacent to the management aggressor row, with the victim row interposed therebetween. However, this is provided as an example. According to an embodiment, the memory device 200 may designate a plurality of rows having relatively large ERH count data from among the rows managed in the ERH register as a management aggressor row.

Accordingly, the extended row hammer refresh operation may be performed in association with a row having the maximum ERH count data from among rows accessed during a given time from a current time point. As a result, the memory device 200 may manage the risk of occurrence of the extended row hammer phenomenon for each row to be an appropriate level or lower. This structural configuration and operation may mean that the extended row hammer phenomenon for each row is effectively prevented.

In an embodiment, the memory device 200 may perform the row hammer refresh operation and the extended row hammer refresh operation for each row, based on first information used to perform the row hammer refresh operation and second information used to perform the extended row hammer refresh operation, and the first information and the second information may be managed in the same register.

For example, the memory device 200 may designate a row having the maximum RH count data from among rows managed in the register as a management aggressor row and may perform the refresh operation on a victim row adjacent to the management aggressor row.

For example, the memory device 200 may determine whether a turn at which the extended row hammer refresh operation is to be performed comes, based on ERH flag data of rows managed in the register. When a turn at which the extended row hammer refresh operation on a specific row is to be performed comes, the memory device 200 may designate the corresponding row as a management aggressor row and may perform the refresh operation on an extended victim row adjacent to the management aggressor row.

As described above, the row hammer refresh operation and/or the extended row hammer refresh operation may be performed selectively or sequentially. As a result, the memory device 200 may manage the risk of occurrence of the row hammer phenomenon and the risk of occurrence of the extended row hammer phenomenon for each row to be an appropriate level or lower. This structural configuration and operation may mean that the row hammer phenomenon and the extended row hammer phenomenon are effectively prevented. In some embodiments, since the memory device 200 manages the number of times of execution of the row hammer refresh operation for each row through the ERH flag data, the memory device 200 may easily set an execution ratio of the row hammer refresh operation to the extended row hammer refresh operation for each row.

However, this is provided as an example. According to an embodiment, the memory device 200 may designate a plurality of rows having relatively large RH count data from among rows managed in the RH register as a management aggressor row corresponding to the row hammer refresh operation and may designate a plurality of rows as a management aggressor row corresponding to the extended row hammer refresh operation, based on ERH flag data of rows managed in the register.

In one example, a first register configured to store the row hammer count data of the at least one row among the plurality of rows may be referred to as a first register; and a register configured to store the extended row hammer count data of the at least one row among the plurality of rows may be referred to as a second register.

### [Management of RH Register and Row Hammer Refresh Operation]

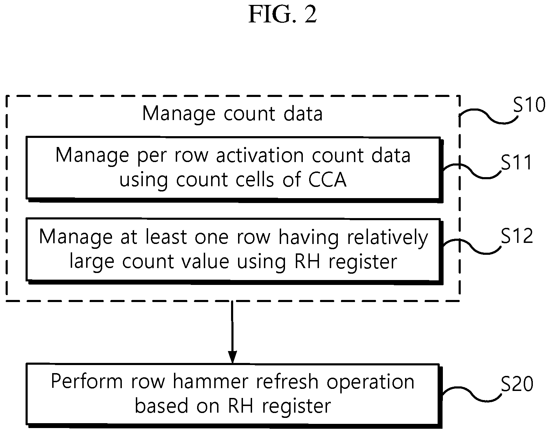

FIG. 2 is a flowchart for describing an operation of a memory device according to an embodiment. An operation method to be described with reference to FIG. 2 may correspond, for example, to the operation method for preventing the row hammer phenomenon from among operation methods of the memory device 200 of FIGS. 1A and 1B.

In operation S 10, an operation of managing count data may be performed. In some embodiments, the operation S10 may include operation S11 and operation S12.

For example, in operation S11, the memory device 200 may manage per row activation count data using the count cells of the count cell area CCA. For example, in some embodiments, the memory device 200 may manage RH count data being the number of times of access of each of a plurality of rows included in a bank, by using the count cells of the count cell area CCA. In this case, RH count data stored in a count cell may be referred to as "per row activation count (PRAC) data"

For example, in operation S12, the memory device 200 may manage at least one row having a relatively large count value using the RH register. For example, in some embodiments, the memory device 200 may manage a row having relatively large RH count data from among the plurality of rows included in the bank, by using the RH register. For example, the memory device 200 may manage an address and RH count data associated with a row having relatively large RH count data from among the plurality of rows included in the bank in the RH register, based on a comparison result of an address and/or RH count data of a target row and an address and/or RH count data of a row managed in the RH register.

In this case, the operation of managing the RH count data by using the count cell area CCA and the operation of managing the row with relatively large RH count data by using the RH register may be sequentially performed or may be performed to overlap each other on time.

In operation S20, the row hammer refresh operation may be performed based on the RH register.

For example, the memory device 200 may designate a row having the maximum RH count data from among rows managed in the RH register as a management aggressor row and may perform the refresh operation on a victim row adjacent to the management aggressor row. In this case, the management aggressor row may be the most accessed row among rows accessed during a given time from a current time point. Accordingly, the memory device 200 may manage the risk of occurrence of the row hammer phenomenon for each row to be an appropriate level or lower. This structural configuration and operation may mean that the row hammer phenomenon is effectively prevented.

### [Management of ERH Register and Extended Row Hammer Refresh Operation]

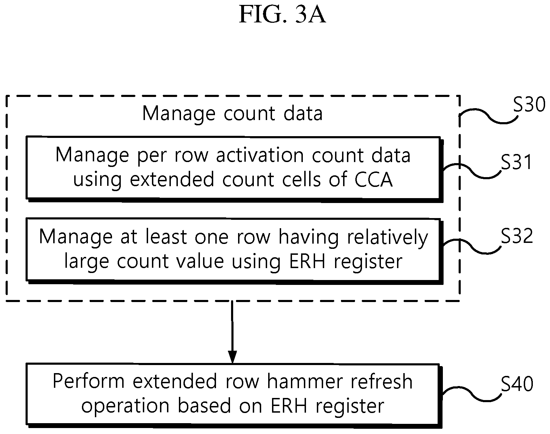

FIG. 3A is a flowchart for describing an operation of a memory device according to an embodiment. An operation method to be described with reference to FIG. 3A may correspond, for example, to the operation method for preventing the extended row hammer phenomenon from among operation methods of the memory device 200 of FIGS. 1A and 1B.

In operation S30, an operation of managing count data may be performed. In some embodiments, the operation S30 may include operation S31 and operation S32.

For example, in operation S31, the memory device 200 may manage per row activation count data using the extended count cells of count cell area CCA. For example, in some embodiments, the memory device 200 may manage ERH count data being the number of times of access of each of a plurality of rows included in a bank, by using the extended count cells of the count cell area CCA. In this case, ERH count data stored in an extended count cell may be referred to as "per row activation count (PRAC) data"

For example, in operation S32, the memory device 200 may manage at least one row having a relatively large count value using the ERH register. For example, in some embodiments, the memory device 200 may manage a row having relatively large ERH count data from among the plurality of rows included in the bank, by using the ERH register. For example, the memory device 200 may manage an address and ERH count data associated with a row having relatively large ERH count data from among the plurality of rows included in the bank in the ERH register, based on a comparison result of an address and/or ERH count data of a target row and an address and/or ERH count data of a row managed in the ERH register.

In this case, the operation of managing the ERH count data by using the count cell area CCA and the operation of managing the row with relatively large ERH count data by using the ERH register may be sequentially performed or may be performed to overlap each other on time.

In operation S40, the extended row hammer refresh operation may be performed based on the ERH register.

For example, the memory device 200 may designate a row having the maximum ERH count data from among rows managed in the ERH register as a management aggressor row and may perform the refresh operation on an extended victim row adjacent to the management aggressor row. Herein, the extended victim row may be a row disposed adjacent to the management aggressor row, with the victim row interposed therebetween.

In this case, the management aggressor row may be the most accessed row among rows accessed during a given time from a current time point. Accordingly, the memory device 200 may manage the risk of occurrence of the extended row hammer phenomenon for each row to be an appropriate level or lower. This structural configuration and operation may mean that the extended row hammer phenomenon is effectively prevented.

RH count data stored in the RH register and the count cell may be reset when the row hammer refresh operation is performed, and ERH count data stored in the ERH register and the extended count cell may be reset when the extended row hammer refresh operation is performed. The row hammer refresh operation and the extended row hammer refresh operation may be performed at different time points. Accordingly, the RH count data and the ERH count data may have different values at the same time point.

In some embodiments, an execution ratio of the row hammer refresh operation to the extended row hammer refresh operation may be 1:1 or may be n:1 (n being a natural number of 2 or more). For example, the disturbance which the victim row experiences due to the frequent access of a specific aggressor row may be larger than the disturbance which an extended victim row experiences due to the frequency access. Accordingly, a reference value of RH count data for entering a row hammer refresh mode may be set to be less than a reference value of ERH count data for entering an extended row hammer refresh mode. Since the reference value of RH count data for entering the row hammer refresh mode and the reference value of ERH count data for entering the extended row hammer refresh mode are differently set, the execution ratio of the row hammer refresh operation to the extended row hammer refresh operation may be set. Accordingly, the row hammer phenomenon and the extended row hammer phenomenon may be effectively prevented.

### [Management of ERH Flag Data and Extended Row Refresh Operation]

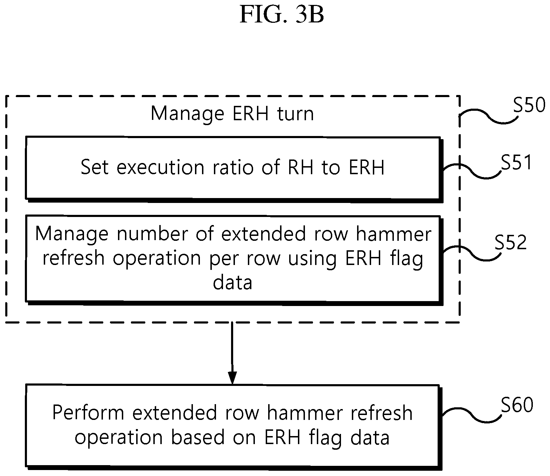

FIG. 3B is a flowchart for describing an operation of a memory device according to an embodiment. An operation method to be described with reference to FIG. 3B may correspond, for example, to the operation method for preventing the extended row hammer phenomenon from among operation methods of the memory device 200 of FIGS. 1A and 1B.

In operation S50, an operation of managing an ERH turn may be performed. For example, in some embodiments, an operation of managing whether a turn at which the extended row hammer refresh operation is to be performed comes may be performed. In some embodiments, the operation S50 may include operation S51 and operation S52.

For example, in operation S51, the memory device 200 may set an execution ratio of the row hammer refresh operation to the extended row hammer refresh operation.

In general, the disturbance which a victim row experiences due to the frequent access to a specific aggressor row is larger than the disturbance which an extended victim row experiences due to the frequency access. Accordingly, the refresh operation on the victim row (i.e., the row hammer refresh operation) may be performed more frequently than the refresh operation on the extended victim row (i.e., the extended row hammer refresh operation). In this case, the execution ratio of the row hammer refresh operation to the extended row hammer refresh operation may be set to n:1 (n being a natural number of 2 or more). However, this is provided as an example. According to an embodiment, the execution ratio of the row hammer refresh operation to the extended row hammer refresh operation may be set to 1:1.

For example, in operation S52, the memory device 200 may manage the number of times of execution of the extended row hammer refresh operation for each row.

In an embodiment, the memory device 200 may manage a number of extended row hammer refresh operations per row using ERH flag data. For example, in some embodiments, the memory device 200 may manage the number of times of execution of the extended row hammer refresh operation for each row by using an extended count cell of the count cell area CCA. In this case, the number of times of execution of the extended row hammer refresh operation of each row may be stored in an extended count cell of the corresponding row as flag data. The number of times of execution of the extended row hammer refresh operation stored in the extended count cell may be referred to as "ERH flag data".

In an embodiment, the ERH flag data may be together managed in the RH register. In this case, the entry of the RH register may include a row address, RH count data corresponding to the row address, and ERH flag data corresponding to the row address. However, this is provided as an example. According to an embodiment, a separate register which stores ERH flag data and a row address associated with the ERH flag data may be provided.

In operation S60, the extended row hammer refresh operation may be performed based on the ERH flag data.

For example, when the ERH flag data reaches a given value, the memory device 200 may determine that the extended row hammer refresh operation is performed as much as the given number of times. In other words, when the ERH flag data reaches the given value, the memory device 200 may determine that a turn at which the extended row hammer refresh operation is to be performed comes. In this case, the memory device 200 may designate a management aggressor row based on the ERH flag data and may perform the refresh operation on an extended victim row adjacent to the management aggressor row. Accordingly, the memory device 200 may manage the risk of occurrence of the extended row hammer phenomenon for each row to be an appropriate level or lower. This structural configuration and operation may mean that the extended row hammer phenomenon is effectively prevented.

Since the memory device 200 manages the number of times of execution of the extended row hammer refresh operation for each row through the ERH flag data, the memory device 200 may easily set the execution ratio of the row hammer refresh operation to the extended row hammer refresh operation for each row.

### [Example of Structure of Memory Device Supporting Row Hammer Refresh Operation and Extended Row Hammer Refresh Operation]

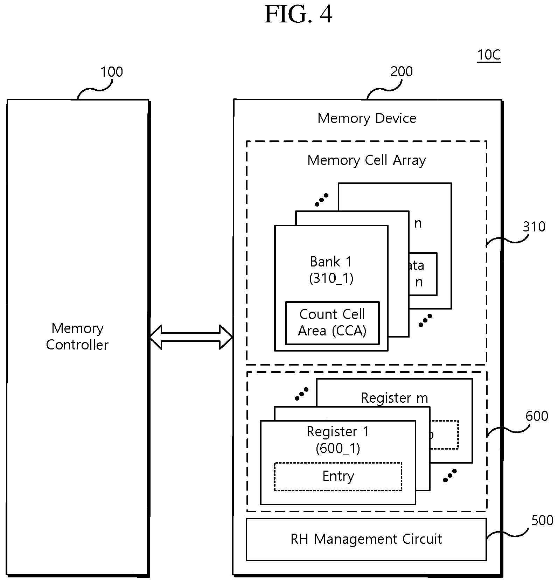

FIG. 4 is a block diagram illustrating an example of a memory system according to an embodiment. A memory system 10C of FIG. 4 is similar to the memory system 10A and 10B of FIGS. 1A and 1B. Thus, the same or similar components may be marked by the same or similar reference numerals/signs, and additional description associated with the same or similar components will be omitted to avoid redundancy.

Referring to FIG. 4, the memory system 10C may include the memory controller 100 and the memory device 200. The memory device 200 may include the memory cell array 310, the register group 600, and a row hammer management circuit 500.

The memory cell array 310 may include the plurality of banks 310_1 to 310_n, and each of the plurality of banks 310_1 to 310_n may include the count cell area CCA.

In an embodiment, the count cell area CCA may include a plurality of count cells corresponding respectively to a plurality of rows, and each of the plurality of count cells may store the number of times of access of the corresponding row as RH count data.

In an embodiment of the count cell area CCA may include a plurality of extended count cells corresponding respectively to the plurality of rows, and each of the plurality of extended count cells may store the number of times of access of the corresponding row as ERH count data. An extended cell which stores ERH count data may be referred, for example, to as an "extended count cell".

In an embodiment, the count cell area CCA may include the plurality of extended count cells corresponding to the plurality of rows, and each of the plurality of extended count cells may store the number of times of execution of the extended row hammer refresh operation for the corresponding row as ERH flag data. An extended count cell which stores ERH count data may be referred, for example, to as a "flag cell".

The register group 600 may include the plurality of registers 600_1 to 600_m.

In an embodiment, the plurality of registers 600_1 to 600_m may include an RH register. The RH register may store an address and RH count data, which are associated with a row having relatively large RH count data from among a plurality of rows included in the corresponding bank.

In an embodiment, the plurality of registers 600_1 to 600_m may include an ERH register. The ERH register may store an address and ERH count data, which are associated with a row having relatively large ERH count data from among a plurality of rows included in the corresponding bank.

In an embodiment, the plurality of registers 600_1 to 600_m may include a register which stores information used for the row hammer refresh operation and information used for the extended row hammer refresh operation together. For example, the register may store an address and RH count data, which are associated with a row having relatively large RH count data from among the plurality of rows included in the corresponding bank, and ERH flag data associated with the row having relatively large RH count data.

The row hammer management circuit 500 may manage RH count data, ERH count data, and/or ERH flag data stored in the count cell area CCA.

In an embodiment, the row hammer management circuit 500 may manage RH count data of each of the plurality of rows, based on a command received from the memory controller 100.

For example, when an active command for a target row is applied from the memory controller 100, the row hammer management circuit 500 may read RH count data from a count cell of the target row, may generate modified RH count data by increasing the read RH count data as much as "1", and may again write the modified RH count data to the count cell of the target row. However, this is provided as an example. According to an embodiment, the row hammer management circuit 500 may manage the RH count data of the target row based on a precharge command. According to an embodiment, the row hammer management circuit 500 may generate modified RH count data by increasing the RH count data as much as "k" (k being a natural number of 2 or more), in consideration of the activation time of the target row.

In an embodiment, the row hammer management circuit 500 may manage ERH count data of each of the plurality of rows, based on a command received from the memory controller 100.

For example, when the active command for a target row is applied from the memory controller 100, the row hammer management circuit 500 may read ERH count data from an extended cell of the target row, may generate modified ERH count data by increasing the read ERH count data as much as "1", and may again write the modified ERH count data to the extended cell of the target row. However, this is provided as an example. According to an embodiment, the row hammer management circuit 500 may manage the ERH count data of the target row based on the precharge command. According to an embodiment, the row hammer management circuit 500 may generate modified ERH count data by increasing the ERH count data as much as "k" (k being a natural number of 2 or more), in consideration of the activation time of the target row.

In an embodiment, in the extended row hammer refresh operation, the row hammer management circuit 500 may manage ERH count data for each of the plurality of rows.

For example, when the extended row hammer refresh operation on a specific row is performed, the row hammer management circuit 500 may read ERH flag data of the specific row from the register and may generate modified ERH flag data by increasing the read ERH flag data as much as "1". Afterwards, the row hammer management circuit 500 may write the modified ERH flag data to each of the register and the extended count cell.

In some embodiments, when the extended row hammer refresh operation on a specific row is performed, the row hammer management circuit 500 may read ERH flag data of the specific row from the extended cell, may generate modified ERH flag data by increasing the read ERH flag data as much as "1", and may write the modified ERH flag data to each of the register and the extended cell.

The row hammer management circuit 500 may update the register group 600 by using the modified RH count data, the modified ERH count data, and/or the modified ERH flag data.

In an embodiment, the row hammer management circuit 500 may update the RH register by using the modified RH count data.

For example, the row hammer management circuit 500 may select an RH register, which corresponds to a bank to which the target row belongs, from among RH registers of the register group 600. Afterwards, the row hammer management circuit 500 may compare addresses and/or RH count data of rows managed in the selected RH register with the address and/or the modified RH count data of the target row and may update the RH register based on a comparison result.

For example, when an entry corresponding to the target row is already present in the RH register, the row hammer management circuit 500 may update RH count data of the entry corresponding to the target row by using the modified RH count data.

For example, when at least one of pieces of count data of entries of the RH register is less than the RH count data of the target row, the row hammer management circuit 500 may replace the entry of the register corresponding to the minimum RH count data with the address and the modified RH count data of the target row.

For example, when an entry corresponding to the target row is absent from the register and an empty space is present in the RH register, the row hammer management circuit 500 may generate a new entry in the RH register by using the address and the modified RH count data of the target row.

For example, when the modified RH count data is less than a reference value, the row hammer management circuit 500 may not apply the modified RH count data to the RH register. For example, when the modified RH count data is less than the reference value, the row hammer management circuit 500 may not generate a new entry for the target row in the RH register even though an empty space is present in the RH register.

In an embodiment, the row hammer management circuit 500 may update the ERH register by using the modified ERH count data.

For example, the row hammer management circuit 500 may select an ERH register, which corresponds to a bank to which the target row belongs, from among ERH registers of the register group 600. Afterwards, the row hammer management circuit 500 may compare addresses and/or ERH count data of rows managed in the selected ERH register with the address and/or the modified ERH count data of the target row and may update the ERH register based on a comparison result.

For example, when an entry corresponding to the target row is already present in the ERH register, the row hammer management circuit 500 may update ERH count data of the entry corresponding to the target row by using the modified ERH count data.

For example, when at least one of pieces of ERH count data of entries of the ERH register is less than the ERH count data of the target row, the row hammer management circuit 500 may replace the entry of the ERH register corresponding to the minimum ERH count data with the address and the modified ERH count data of the target row. In one example, when the modified extended row hammer count data corresponding to the target row is greater than a minimum extended row hammer count data among extended row hammer count data stored in the second register, the row hammer management circuit may replace an entry of the second register corresponding to the minimum extended row hammer count data with the address and the modified extended row hammer count data of the target row.

For example, when an entry corresponding to the target row is absent from the register and an empty space is present in the ERH register, the row hammer management circuit 500 may generate a new entry in the ERH register by using the address and the modified ERH count data of the target row.

For example, when the modified ERH count data is less than the reference value, the row hammer management circuit 500 may not apply the modified ERH count data to the ERH register. For example, when the modified ERH count data is less than the reference value, the row hammer management circuit 500 may not generate a new entry for the target row in the ERH register even though an empty space is present in the ERH register.

In an embodiment, the row hammer management circuit 500 may update the register by using the modified ERH flag data.

For example, when the extended row hammer refresh operation on a specific row is performed, the row hammer management circuit 500 may generate modified ERH flag data. Afterwards, the row hammer management circuit 500 may update the register by again storing the modified ERH flag data in the register.

The memory device 200 may perform the row hammer refresh operation and/or the extended row hammer refresh operation, based on the RH register, the ERH register, and/or the register in which information used for the row hammer refresh operation and used necessary for the extended row hammer refresh operation are together managed.

In an embodiment, the memory device 200 may perform the row hammer refresh operation, based on information about a row managed in the RH register. For example, the memory device 200 may designate at least one row having the maximum RH count data from among rows managed in the RH register as a management aggressor row and may perform the refresh operation on a victim row adjacent to the management aggressor row.

In an embodiment, the memory device 200 may perform the extended row hammer refresh operation, based on information about a row managed in the ERH register. For example, the memory device 200 may designate at least one row having the maximum ERH count data from among rows managed in the ERH register as a management aggressor row and may perform the refresh operation on an extended victim row adjacent to the management aggressor row.

In an embodiment, the memory device 200 may perform the row hammer refresh operation and the extended row hammer refresh operation for each row, based on one register. For example, the memory device 200 may designate at least one row having the maximum RH count data from among rows managed in the register as a management aggressor row and may perform the refresh operation on a victim row adjacent to the management aggressor row. For example, the memory device 200 may determine whether a turn at which the extended row hammer refresh operation is to be performed comes, based on ERH flag data of rows managed in the register. When a turn at which the extended row hammer refresh operation on at least one specific row is to be performed comes, the memory device 200 may designate the at least one specific row as a management aggressor row and may perform the refresh operation on an extended victim row adjacent to the management aggressor row.

As described above, since the memory device 200 supports the row hammer refresh operation and/or the extended row hammer refresh operation, the memory device 200 may effectively prevent the row hammer phenomenon and/or the extended row hammer phenomenon.

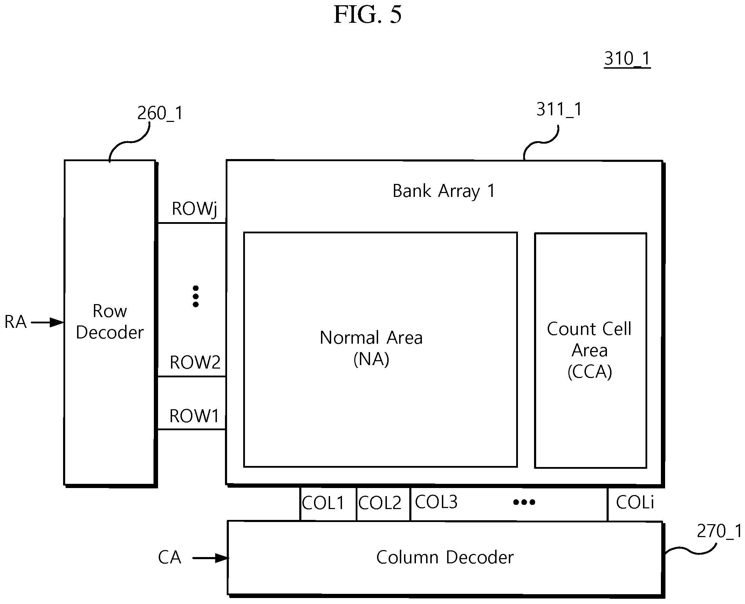

FIG. 5 is a diagram illustrating an example of a bank according to an embodiment. The bank 310_1 of FIG. 5 may correspond, for example, to the first bank 310_1 of FIGS. 1A, 1B, and 4.

Referring to FIG. 5, the first bank 310_1 may include a first bank array 311_1, a row decoder 260_1, and a column decoder 270_1.

The first bank array 311_1 may include a plurality of memory cells. The first bank array 311_1 may include a normal area NA and the count cell area CCA.

The normal area NA may refer to an area of the first bank array 311_1, which is allocated to store user data. In some embodiments, the normal area NA may refer to the remaining area of the first bank array 311_1 other than an area allocated to the count cell area CCA.

The count cell area CCA may refer to an area of the first bank array 311_1, which is allocated to store RH count data, ERH count data, and/or ERH flag data for each of a plurality of rows ROW1 to ROWj.

The row decoder 260_1 may activate one of the plurality of rows ROW1 to ROWj in response to a row address RA. For example, each of the plurality of rows ROW1 to ROWj may correspond to a word line.

The column decoder 270_1 may activate one of a plurality of columns COL1 to COLi in response to a column address CA. For example, each of the plurality of columns COL1 to COLi may correspond to a column selection line (CSL). However, this is provided as an example. According to an embodiment, each of the plurality of columns COL1 to COLi may correspond to a bit line.

In an embodiment, the count cell area CCA may be implemented to include count cells for storing RH count data of the plurality of rows ROW1 to ROWj.

In an embodiment, the count cell area CCA may be implemented to include count cells for storing RH count data of the plurality of rows ROW 1 to ROWj and extended count cells for storing ERH count data of the plurality of rows ROW1 to ROWj.

In an embodiment, the count cell area CCA may be implemented to include count cells for storing RH count data of the plurality of rows ROW 1 to ROWj and extended count cells for storing ERH flag data of the plurality of rows ROW1 to ROWj. An extended count cell which stores ERH flag data may be referred, for example, to as a "flag cell".

In an embodiment, the count cell area CCA may be implemented to include parity cells for performing an error correction operation on at least one of RH count data, ERH count data, and/or ERH flag data.

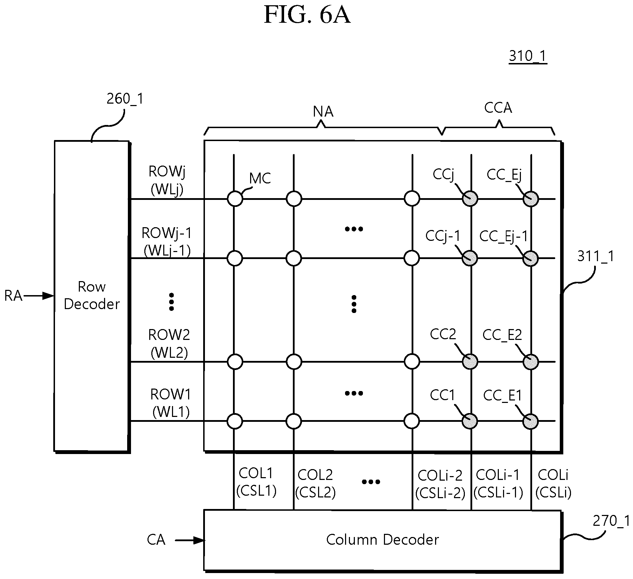

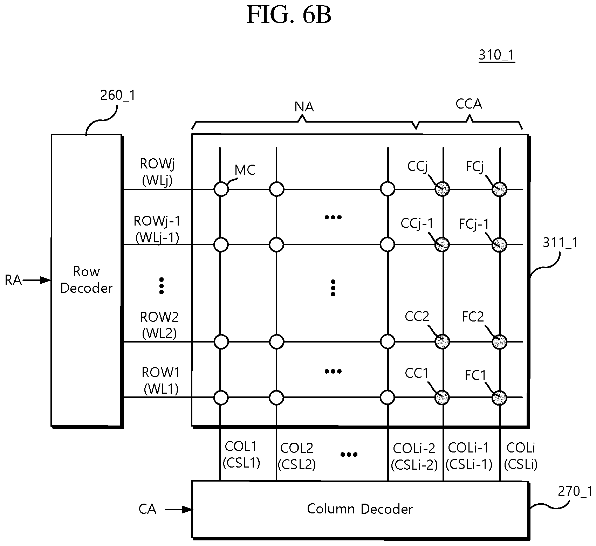

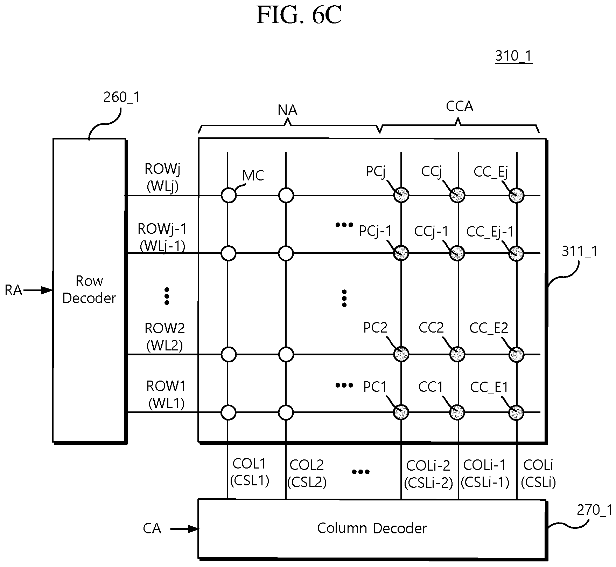

FIG. 6A is a conceptual diagram for describing a configuration of a bank which includes the count cell area CCA implemented to include count cells and extended count cells, according to an embodiment. FIG. 6B is a conceptual diagram for describing a configuration of a bank which includes the count cell area CCA implemented to include count cells and flag cells, according to an embodiment. FIG. 6C is a conceptual diagram for describing a configuration of a bank which includes the count cell area CCA implemented to include count cells, extended count cells, and parity cells, according to an embodiment.

The bank 310_1 to be described with reference to FIGS. 6A to 6C may correspond, for example, to the first bank 310_1 of FIGS. 1A, 1B, 4, and 5.

Referring to FIGS. 6A to 6C, the first bank 310_1 may include the first bank array 311_1, the row decoder 260_1, and the column decoder 270_1.

The first bank array 311_1 may include a plurality of memory cells which are electrically connected to a plurality of word lines WL1 to WLj and a plurality of column selection lines CSL1 to CSLi. The plurality of word lines WL1 to WLj may be defined as the plurality of rows ROW1 to ROWj, and the plurality of column selection lines CSL1 to CSLi may be defined as the plurality of columns COL1 to COLi.

A portion of the first bank array 311_1 may be allocated to the normal area NR, and the remaining portion thereof may be allocated to the count cell area CCA.

In an embodiment, as illustrated in FIG. 6A, memory cells corresponding to at least two of the plurality of columns COL1 to COLi may be allocated to the count cell area CCA.

In this case, each of a plurality of memory cells CC1 to CCj allocated to the count cell area CCA may store RH count data of the corresponding row. The memory cells CC1 to CCj storing the RH count data may be referred to as a "count cell". For example, the first count cell CC1 may store RH count data of the first row ROW1, the second count cell CC2 may store RH count data of the second row ROW2, and the j-th count cell CCj may store RH count data of the j-th row ROWj.

In this case, each of a plurality of memory cells CC_E1 to CCj allocated to the count cell area CCA may store ERH count data of the corresponding row. The memory cells CC_E1 to CC_Ej storing the ERH count data may be referred to as an "extended count cell". For example, the first extended count cell CC_E1 may store ERH count data of the first row ROW1, the second extended count cell CC_E2 may store ERH count data of the second row ROW2, and the j-th extended count cell CC_Ej may store ERH count data of the j-th row ROWj.

In an embodiment, as illustrated in FIG. 6B, memory cells corresponding to at least two of the plurality of columns COL1 to COLi may be allocated to the count cell area CCA.

In this case, each of a plurality of memory cells CC1 to CCj allocated to the count cell area CCA may store RH count data of the corresponding row.

In this case, each of a plurality of memory cells FC1 to FCj allocated to the count cell area CCA may store ERH flag data of the corresponding row. The memory cells FC1 to FCj storing the ERH flag data may be referred to as a "flag cell". For example, the first flag cell FC1 may store ERH flag data of the first row ROW1, the second flag cell FC2 may store ERH flag data of the second row ROW2, and the j-th flag cell FCj may store ERH flag data of the j-th row ROWj.

In an embodiment, as illustrated in FIG. 6C, memory cells corresponding to at least three of the plurality of columns COL1 to COLi may be allocated to the count cell area CCA.

In this case, each of a plurality of memory cells CC_E1 to CC_Ej corresponding to the i-th column COLi may store ERH count data of the corresponding row, each of a plurality of memory cells CC1 to CCj corresponding to the (i-1)-th column COLi-1 may store RH count data of the corresponding row, and each of a plurality of memory cells PC1 to PCj corresponding to the (i-2)-th column COLi-2 may store parity data associated with the corresponding RH count data and/or the ERH count data. The memory cells PC1 to PCj storing the parity data may be referred to as a "parity cell".

For example, the first parity cell PC1 may store parity data associated with the RH count data stored in the first count cell CC1 and/or the ERH count data stored in the first extended count cell CC_E1, and the second parity cell PC2 may store parity data associated with the RH count data stored in the second count cell CC2 and/or the ERH count data stored in the second extended count cell CC_E2.

The RH count data, ERH count data and/or parity data for each of the plurality of rows ROW1 to ROWj may be managed in the count cell area CCA of the first bank 310_1 through the above method.

In FIGS. 6A to 6C, the description is given as memory cells corresponding to one of the plurality of columns COL1 to COLi are allocated to the RH count cells, the ERH count cells, or the parity cells. However, this is provided as an example. According to an embodiment, memory cells corresponding to at least two of the plurality of columns COL1 to COLi may be allocated to the RH count cells. Likewise, according to an embodiment, memory cells corresponding to at least two of the plurality of columns COL1 to COLi may be allocated to the ERH count cells, and memory cells corresponding to at least two of the remaining columns among the plurality of columns COL1 to COLi may be allocated to the parity cells.

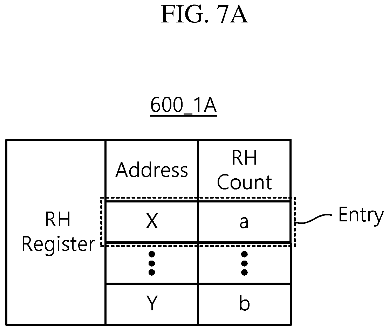

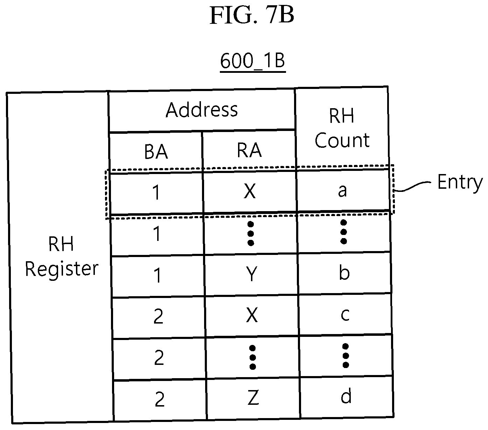

FIGS. 7A and 7B are diagrams for describing an RH register which manages an address and RH count data of a row, according to some embodiments. In FIG. 7A, an example of an RH register corresponding to one bank is illustrated. In FIG. 7B, an example of an RH register corresponding to two banks is illustrated. Each of RH registers 600_1A and 600_1B to be described with reference to FIGS. 7A and 7B may correspond, for example, to the register 600_1 of FIGS. 1A, 1B, and 4.

Referring to FIG. 7A, the RH register may correspond to one bank and may manage rows having relatively large RH count data from among a plurality of rows of the corresponding bank.

For example, the RH register 600_1A may correspond to the first bank 310_1 (refer to FIGS. 1A, 1B, and 4). The RH register 600_1A may be disposed in a peripheral area of the memory device 200 (refer to FIGS. 1A, 1B, and 4) so as to be adjacent to the first bank 310_1.

The RH register 600_1A may include at least one entry. Each entry may be formed of an address and RH count data of the corresponding row. For example, when a row corresponding to address "X" from among the plurality of rows of the first bank 310_1 is managed by the RH register 600_1A, the address (i.e., "X") and the RH count data (i.e., "a") of the corresponding row may constitute one entry of the RH register 600_1A.

The number of entries of the RH register 600_1A may be less than the number of rows of the first bank 310_1. In other words, the number of rows which are managed in the RH register 600_1A may be less than the number of rows of the first bank 310_1.

In an embodiment, the RH register 600_1A may store an address and RH count data associated with at least one row having relatively large RH count data from among the plurality of rows of the first bank 310_1. In other words, at least one row which is managed in the RH register 600_1A may be a row having relatively large count data from among the plurality of rows of the first bank 310_1.

Referring to FIG. 7B, the RH register may correspond to a plurality of banks and may manage rows each having relatively large RH count data from among a plurality of rows of the corresponding banks.

For example, the RH register 600_1B may correspond to a first bank and a second bank. In this case, the RH register 600_1B may be disposed in the peripheral area of the memory device 200 so as to be adjacent to the first bank and the second bank.

The RH register 600_1B may include at least one entry. Each entry may be formed of a bank address BA, a row address RA, and RH count data. For example, it is assumed that the bank address BA of the first bank is "1" and a row corresponding to the row address RA of "X" from among the plurality of rows of the first bank is managed by the RH register 600_1B. In this case, a bank address (i.e., "1"), a row address (i.e., "X"), and RH count data (i.e., "a") of the corresponding row may constitute one entry of the RH register 600_1B.

In an embodiment, the RH register 600_1B may store an address and RH count data associated with at least one row having relatively large RH count data from among the plurality of rows of the first bank and/or the second bank. In other words, at least one row which is managed in the RH register 600_1B may be a row having relatively large RH count data from among the plurality of rows of the first bank and/or the second bank.

As described with reference to FIGS. 7A and 7B, the RH register may correspond to at least one bank and may store an address and RH count data associated with at least one row having relatively large RH count data from among a plurality of rows included in the corresponding bank. Accordingly, in the row hammer refresh operation, the memory device 200 may effectively perform the row hammer refresh operation based on information of a row managed in the RH register.

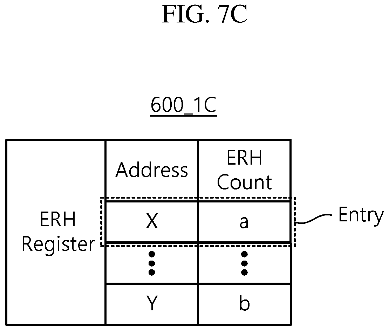

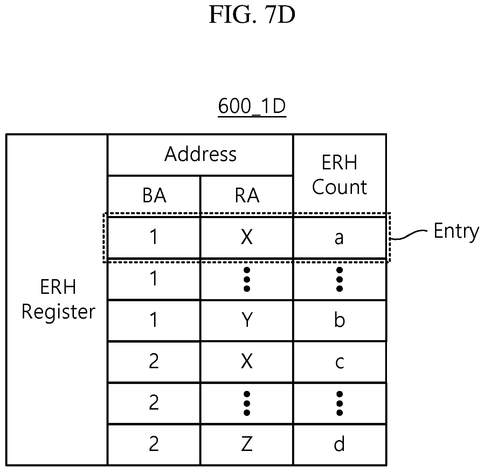

FIGS. 7C and 7D are diagrams for describing an ERH register which manages an address and ERH count data of a row, according to some embodiments. In FIG. 7C, an example of an ERH register corresponding to one bank is illustrated. In FIG. 7D, an example of an ERH register corresponding to two banks is illustrated. Each of ERH registers 600_1C and 600_1D to be described with reference to FIGS. 7C and 7D may correspond, for example, to the register 600_1 of FIGS. 1A, 1B, and 4.

Referring to FIG. 7C, the ERH register may correspond to one bank and may manage rows having relatively large ERH count data from among a plurality of rows of the corresponding bank.

The ERH register 600_1C of FIG. 7C may be implemented, for example, to be similar to the RH register 600_1A of FIG. 7A.

For example, the ERH register 600_1C may include at least one entry. Each entry may be formed of an address and ERH count data of the corresponding row. The number of entries of the ERH register 600_1C may be less than the number of rows of the first bank 310_1. The ERH register 600_1C may store an address and ERH count data associated with at least one row having relatively large ERH count data from among the plurality of rows of the first bank 310_1.

Referring to FIG. 7D, the ERH register may correspond to a plurality of banks and may manage rows each having relatively large ERH count data from among a plurality of rows of the plurality of banks.

The ERH register 600_1D of FIG. 7D may be implemented, for example, to be similar to the RH register 600_1B of FIG. 7B.

For example, the ERH register 600_1D may correspond to a first bank and a second bank. The ERH register 600_1D may include at least one entry, and the entry may be formed of a bank address BA, a row address RA, and ERH count data. The ERH register 600_1D may store an address and ERH count data associated with at least one row having relatively large ERH count data from among the plurality of rows of the first bank and/or the second bank.

As described with reference to FIGS. 7C and 7D, the ERH register may correspond to at least one bank and may store an address and ERH count data associated with at least one row having relatively large ERH count data from among a plurality of rows included in the corresponding bank. Accordingly, in the extended row hammer refresh operation, the memory device 200 may effectively perform the row hammer refresh operation based on information of a row managed in the ERH register.

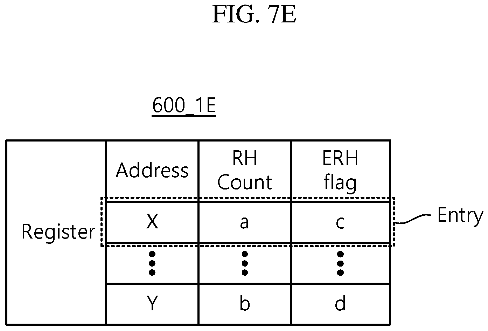

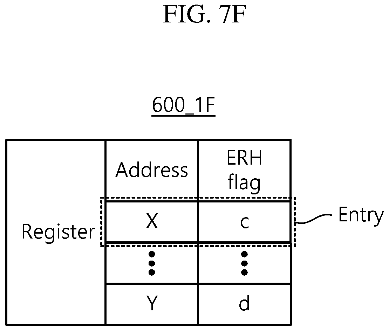

FIGS. 7E and 7F are diagrams for describing a register which manages an address and ERH flag data of a row, according to some embodiments. In FIG. 7E, an example of a register which manages RH count data and ERH flag data together is illustrated. In FIG. 7F, an example of a register which manages a row address and ERH flag data separately is illustrated. Each of registers 600_1E and 600_1F to be described with reference to FIGS. 7E and 7F may correspond, for example, to the register 600_1 of FIGS. 1A, 1B, and 4.

Referring to FIG. 7E, the register may manage ERH flag data used to perform the extended row hammer refresh operation together, in addition to a row address and RH count data used to perform the row hammer refresh operation.

For example, the register 600_1E may correspond to the first bank 310_1 (refer to FIGS. 1A, 1B, and 4). The register 600_1E may be disposed in a peripheral area of the memory device 200 (refer to FIGS. 1A, 1B, and 4) so as to be adjacent to the first bank 310_1.

The register 600_1E may include at least one entry. Each entry may be formed of an address, RH count data, and ERH flag data of the corresponding row. For example, when a row corresponding to address "X" from among the plurality of rows of the first bank 310_1 is managed by the register 600_1E, the address (i.e., "X") of the corresponding row, the RH count data (i.e., "a") being the number of times of activation of the corresponding row, and the ERH flag data (e.g., "c") being the number of times of execution of the extended row hammer refresh operation of the corresponding row may constitute one entry of the register 600_1E. The number of entries of the register 600_1E may be less than the number of rows of the first bank 310_1.

In an embodiment, the register 600_1E may store an address and RH count data associated with at least one row having relatively large RH count data from among the plurality of rows of the first bank 310_1. Accordingly, in the row hammer refresh operation, the memory device 200 may effectively perform the row hammer refresh operation based on information of a row managed in the register 600_1E.

In an embodiment, the register 600_1E may store ERH flag data associated with at least one row having relatively large RH count data from among the plurality of rows of the first bank 310_1. When the extended row hammer operation is performed based on information about a row managed in the register 600_1E, the ERH flag data of the corresponding row may be updated. For example, the ERH flag data corresponding to the row where the extended row hammer operation is performed may increase as much as "+1", and the modified ERH flag data may be again stored in the register 600_1E.

Because there is performed the extended row hammer refresh operation on a row selected from rows managed in the register 600_1E, the ERH flag data being the number of times of execution of the extended row hammer operation may also be efficiently managed. In addition, in the extended row hammer refresh operation, the memory device 200 may effectively perform the extended row hammer refresh operation based on the ERH flag data managed in the register 600_1E.

Meanwhile, the above description is provided as an example, and embodiments are not limited thereto. For example, as illustrated in FIG. 7F, the refresh according to an embodiment may separately manage a row address and ERH flag data used to perform the extended row hammer refresh operation.

The description will be given in detail with reference to FIG. 7F. The register 600_1F may correspond to the first bank 310_1 (refer to FIGS. 1A, 1B, and 4). The register 600_1F may include at least one entry, and the entry may be formed of an address and ERH flag data of the corresponding row.

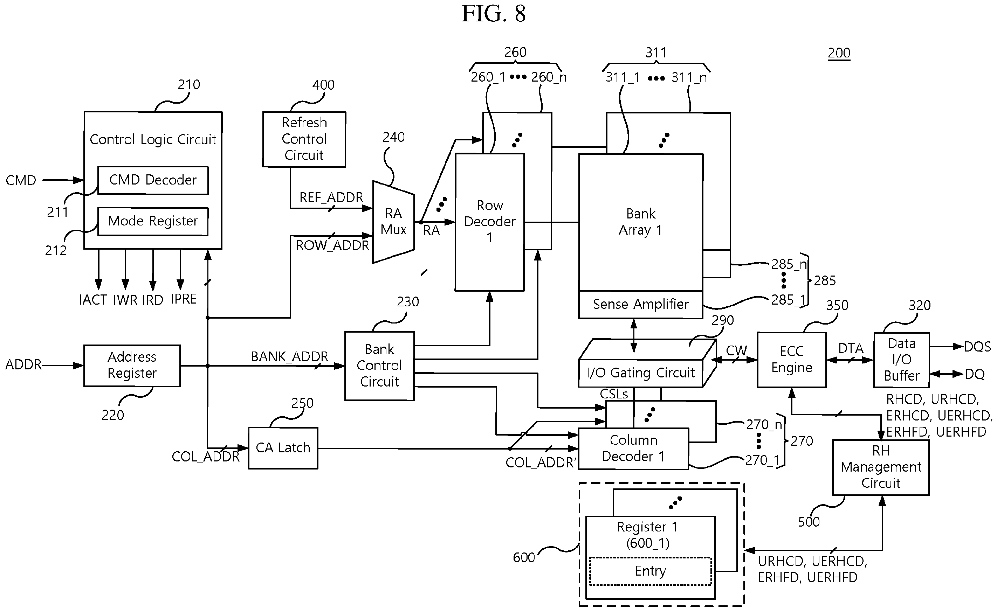

FIG. 8 is a block diagram illustrating an example of the memory device 200 according to an embodiment. The memory device 200 of FIG. 8 may correspond to the memory device 200 of FIGS. 1A, 1B, and 4.

Referring to FIG. 8, the memory device 200 may include a control logic circuit 210, an address register 220, bank control circuit 230, a refresh control circuit 400, a row address multiplexer 240, a column address latch 250, a row decoder 260, a column decoder 270, a bank array group 311, a sense amplifier unit 285, an input/output gating circuit 290, an ECC engine 350, a data input/output buffer 320, the row hammer (RH) management circuit 500, and the register group 600.

The bank array group 311 may include the plurality of bank arrays 311_1 to 311_n. Each of the plurality of bank arrays 311_1 to 311_n may include a plurality of memory cells. For example, each of the plurality of memory cells may be formed at an intersection of a corresponding word line and a corresponding bit line.

The row decoder 260 may include a plurality of sub-row decoders 260_1 to 260_n. Each of the plurality of sub-row decoders 260_1 to 260_n may be connected to the corresponding bank array among the plurality of bank arrays 311_1 to 311_n.

The sense amplifier unit 285 may include a plurality of sense amplifiers 285_1 to 285_n. Each of the plurality of sense amplifiers 285_1 to 285_n may be connected to the corresponding bank array among the plurality of bank arrays 311_1 to 311 _n.

The column decoder 270 may include a plurality of sub-column decoders 270_1 to 270_n. Each of the plurality of sub-column decoders 270_1 to 270_n may be connected to the corresponding bank array among the plurality of bank arrays 311_1 to 311_n through the corresponding sense amplifier.

The plurality of bank arrays 311_1 to 311_n, the plurality of sense amplifiers 285_1 to 285_n, the plurality of sub-column decoders 270_1 to 270_n, and the plurality of sub-row decoders 260_1 to 260_n may constitute a plurality of banks. For example, the first bank array 311_1, the first sense amplifier 285_1, the first sub-column decoder 270_1, and the first sub-row decoder 260_1 may constitute the first bank.

The address register 220 may receive an address ADDR including a bank address BANK_ADDR, a row address ROW_ADDR, and a column address COL_ADDR from the memory controller 100. The address register 220 may provide the received bank address BANK_ADDR to the bank control circuit 230, may provide the received row address ROW_ADDR to the row address multiplexer 240, and may provide the received column address COL_ADDR to the column address latch 250. Also, the address register 220 may provide the bank address BANK_ADDR and the row address ROW_ADDR to the row hammer management circuit 500.

The bank control circuit 230 may generate bank control signals in response to the bank address BANK_ADDR. For example, a sub-row decoder corresponding to the bank address BANK_ADDR from among the plurality of sub-row decoders 260_1 to 260_n may be activated in response to the bank control signals. A sub-column decoder corresponding to the bank address BANK_ADDR from among the plurality of sub-column decoders 270_1 to 270_n may be activated in response to the bank control signals.

The row address multiplexer 240 may receive the row address ROW_ADDR from the address register 220 and may receive a refresh row address REF_ADDR from the refresh control circuit 400. The row address multiplexer 240 may selectively output the row address ROW_ADDR or the refresh row address REF_ADDR as the row address RA. The row address RA output from the row address multiplexer 240 may be applied to each of the plurality of sub-row decoders 260_1 to 260_n.

In response to refresh signals from the control logic circuit 210, in a normal refresh mode, the refresh control circuit 400 may sequentially increase or decrease the refresh row address REF_ADDR.

The refresh control circuit 400 may receive a hammer address in a row hammer refresh mode. Based on the hammer address, the refresh control circuit 400 may output, as the refresh row address REF_ADDR, addresses of victim rows adjacent to an aggressor row.

The refresh control circuit 400 may receive the hammer address in the extended row hammer refresh mode. Based on the hammer address, the refresh control circuit 400 may output, as the refresh row address REF_ADDR, addresses of extended victim rows adjacent to an aggressor row.

A sub-row decoder selected by the bank control circuit 230 from among the plurality of sub-row decoders 260_1 to 260_n may activate a word line corresponding to the row address RA output from the row address multiplexer 240. For example, the selected sub-row decoder may apply a word line driving voltage to the word line corresponding to a row address.

The column address latch 250 may receive the column address COL_ADDR from the address register 220 and may temporarily store the received column address COL_ADDR. Also, for example, in a burst mode, the column address latch 250 may sequentially increase the received column address COL_ADDR. The column address latch 250 may apply a temporarily stored or sequentially increased column address COL ADDR' to each of the plurality of sub-column decoders 270_1 to 270_n.

A sub-column decoder activated by the bank control circuit 230 from among the plurality of sub-column decoders 270_1 to 270_n may activate a sense amplifier corresponding to the bank address BANK_ADDR and the column address COL_ADDR through the input/output gating circuit 290.

The input/output gating circuit 290 may include circuits gating input/output data. Also, the input/output gating circuit 290 may include data latches for storing codewords output from the plurality of bank arrays 311_1 to 311_n and write drivers for writing data in the plurality of bank arrays 311_1 to 311_n.

In an embodiment, in the read operation, a codeword CW read from a bank array selected from the plurality of bank arrays 311_1 to 311_n may be sensed by a sense amplifier corresponding to the selected bank array and may be stored in the data latches of the input/output gating circuit 290. ECC decoding for the codeword CW stored in the data latches may be performed by the ECC engine 350 so as to be provided to the data input/output buffer 320 as data DTA. The data input/output buffer 320 may generate a data signal DQ based on the data DTA and may provide the data signal DQ to the memory controller 100 together with a strobe signal DQS.

In an embodiment, in the write operation, the data DTA to be written in a bank array selected from the plurality of bank arrays 311_1 to 311_n may be received by the data input/output buffer 320 as the data signal DQ. The data input/output buffer 320 may convert the data signal DQ into the data DTA so as to be provided to the ECC engine 350. The ECC engine 350 may generate parity bits (or parity data) based on the data DTA and may provide the input/output gating circuit 290 with the codeword CW including the data DTA and the parity bits. The input/output gating circuit 290 may write the codeword CW to the selected bank array.

In the write operation, the data input/output buffer 320 may convert the data signal DQ into the data DTA so as to be provided to the ECC engine 350. In the read operation, the data input/output buffer 320 may convert the data DTA provided from the ECC engine 350 into the data signal DQ.

In the write operation, the ECC engine 350 may perform ECC encoding for the data DTA. In the read operation, the ECC engine 350 may perform ECC decoding for the codeword CW.

The ECC engine 350 may perform ECC encoding and ECC decoding for count data CNTD provided from the row hammer management circuit 500.

The control logic circuit 210 may control the operation of the memory device 200. For example, the control logic circuit 210 may generate control signals such that the memory device 200 performs the write operation, the read operation, the normal refresh operation, the row hammer refresh operation, and the extended row hammer refresh operation. The control logic circuit 210 may include a command (CMD) decoder 211 which decodes a command CMD received from the memory controller 100 and a mode register (MRS) 212 for setting an operation mode of the memory device 200.

The command (CMD) decoder 211 may decode the command CMD to generate internal command signals such as an internal active signal IACT, an internal precharge signal IPRE, an internal read signal IRD, and an internal write signal IWR. Also, the command decoder 211 may generate control signals corresponding to the command CMD by decoding a chip select signal, a command/address signal, etc.

In an embodiment, the row hammer (RH) management circuit 500 may receive RH count data RHCD from the ECC engine 350. The row hammer management circuit 500 may modify the RH count data RHCD and may again provide modified RH count data URHCD to the ECC engine 350.

For example, when the active command for a target row is applied, the RH count data RHCD stored in the count cell of the target row and the parity data stored in the parity cell of the target row may be provided to the ECC engine 350. The ECC engine 350 may perform the ECC decoding operation on the RH count data RHCD by using the parity data and may then transfer the RH count data RHCD to the row hammer management circuit 500.

The row hammer (RH) management circuit 500 may generate the modified RH count data URHCD by increasing the RH count data RHCD as much as "1" or increasing the RH count data RHCD as much as "k" (k being a natural number of 2 or more) in consideration of the activation time of the target row. The row hammer management circuit 500 may provide the modified RH count data URHCD to the ECC engine 350, and the ECC engine 350 may generate the parity data through the ECC encoding operation on the modified RH count data URHCD. The modified RH count data URHCD and the parity data associated with the modified RH count data URHCD may be stored in the count cell and the parity cell of the target row.

The row hammer (RH) management circuit 500 may transmit an address and the modified RH count data URHCD of the target row to the register group 600. The row hammer management circuit 500 may selectively update the register group 600 by using the address and the modified RH count data URHCD of the target row.

For example, the row hammer (RH) management circuit 500 may select an RH register, which corresponds to a bank to which the target row belongs, from among RH registers of the register group 600. The row hammer management circuit 500 may update the RH register based on a comparison result of an address and/or RH count data managed in the selected RH register with the address and/or the modified RH count data URHCD of the target row. For example, when at least one of pieces of RH count data of entries of the RH register is less than modified RH count data URHCD of the target row, the row hammer management circuit 500 may replace the entry of the register corresponding to the minimum modified RH count data URHCD with the address and the modified RH count data URHCD of the target row.

As described above, since the memory device 200 manages an address and RH count data associated with a row having relatively large RH count data from among a plurality of rows through the register group 600, the memory device 200 may manage the risk of occurrence of the row hammer phenomenon for each row to be an appropriate level or lower and may effectively prevent the row hammer phenomenon.

In an embodiment, the row hammer (RH) management circuit 500 may receive ERH count data ERHCD from the ECC engine 350. The row hammer management circuit 500 may modify the ERH count data ERHCD and may again provide modified ERH count data UERHCD to the ECC engine 350.

For example, when the active command for a target row is applied, the ERH count data ERHCD stored in the extended count cell of the target row and the parity data stored in the parity cell of the target row may be provided to the ECC engine 350. The ECC engine 350 may perform the ECC decoding operation on the ERH count data ERHCD by using the parity data and may then transfer the ERH count data ERHCD to the row hammer management circuit 500.

The row hammer (RH) management circuit 500 may generate the modified ERH count data UERHCD by increasing the ERH count data ERHCD as much as "1" or increasing the ERH count data ERHCD as much as "k" (k being a natural number of 2 or more) in consideration of the activation time of the target row. The row hammer management circuit 500 may provide the modified ERH count data UERHCD to the ECC engine 350, and the ECC engine 350 may generate the parity data through the ECC encoding operation on the modified ERH count data UERHCD. The modified ERH count data UERHCD and the parity data associated with the modified ERH count data UERHCD may be stored in the extended count cell and the parity cell of the target row.

The row hammer (RH) management circuit 500 may transmit an address and the modified ERH count data UERHCD of the target row to the register group 600. The row hammer management circuit 500 may selectively update the register group 600 by using the address and the modified ERH count data UERHCD of the target row.

For example, the row hammer (RH) management circuit 500 may select an ERH register, which corresponds to a bank to which the target row belongs, from among registers of the register group 600. The row hammer management circuit 500 may update the ERH register based on a comparison result of an address and/or ERH count data managed in the selected ERH register with the address and/or the modified ERH count data UERHCD of the target row. For example, when at least one of pieces of ERH count data of entries of the ERH register is less than modified ERH count data UERHCD of the target row, the row hammer management circuit 500 may replace the entry of the register corresponding to the minimum modified ERH count data UERHCD with the address and the modified ERH count data URHCD of the target row.

In one example, when the modified extended row hammer count data corresponding to the target row is greater than a minimum extended row hammer count data among extended row hammer count data stored in the second register, the row hammer management circuit replaces an entry of the second register corresponding to the minimum extended row hammer count data with the address and the modified extended row hammer count data of the target row.

As described above, since the memory device 200 manages an address and ERH count data associated with a row having relatively large ERH count data from among a plurality of rows through the register group 600, the memory device 200 may manage the risk of occurrence of the extended row hammer phenomenon for each row to be an appropriate level or lower and may effectively prevent the extended row hammer phenomenon.

In an embodiment, the row hammer (RH) management circuit 500 may receive ERH flag data ERHFD from the register group 600 and/or the ECC engine 350. The row hammer management circuit 500 may modify the ERH flag data ERHFD and may again provide modified ERH flag data UERHFD to the register group 600 and/or the ECC engine 350.

For example, when the extended row hammer refresh operation is performed, the ERH flag data ERHFD of the corresponding management aggressor row may be transferred from the corresponding register of the register group 600 to the row hammer management circuit 500. The row hammer management circuit 500 may increase the ERH flag data ERHFD as much as "1" or may increase the ERH flag data ERHFD as much as "k" (k being a natural number of 2 or more) in consideration of the RH count data corresponding to the management aggressor row. Accordingly, the modified ERH flag data UERHFD may be generated. The row hammer management circuit 500 may write the modified ERH flag data UERHFD to the corresponding register or may write the modified ERH flag data UERHFD to the flag cell through the ECC engine 350 and the input/output gating circuit 290.

In some embodiments, when the extended row hammer refresh operation is performed, the ERH flag data ERHFD stored in the flag cell of the corresponding management aggressor row and the parity data stored in the parity cell of the corresponding management aggressor row may be provided to the ECC engine 350. The ECC engine 350 may perform the ECC decoding operation on the ERH flag data ERHFD by using the parity data and may then transfer the ERH flag data ERHFD to the row hammer management circuit 500. Afterwards, the row hammer management circuit 500 may modify the ERH flag data ERHFD and may again provide the modified ERH flag data UERHFD to the corresponding register and/or the corresponding flag cell.

As described above, since the memory device 200 manages the number of times of execution of the extended row hammer refresh operation for each row through the ERH flag data, the memory device 200 may easily set the execution ratio of the row hammer refresh operation to the extended row hammer refresh operation for each row.

In FIG. 8, the description is given as the memory device 200 includes the ECC engine 350. However, this is provided as an example. According to an embodiment, the memory device 200 may omit an ECC engine.

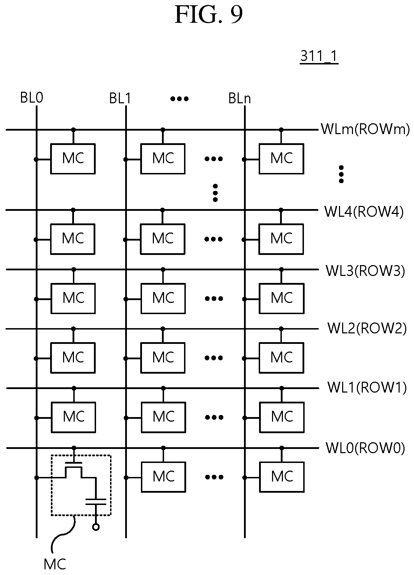

FIG. 9 is a diagram illustrating an example of a bank array according to an embodiment. The bank array 311_1 of FIG. 9 may correspond, for example, to the first bank array 311_1 of FIG. 8.

Referring to FIG. 9, the first bank array 311_1 may include a plurality of word lines WL0 to WLm, a plurality of bit lines BL0 to BLn, and a plurality of memory cells MC disposed at intersections of the word lines WL0 to WLm and the bit lines BL0 to BLn.

In an embodiment, each of the memory cells MC may be a DRAM cell. For example, each of the memory cells MC may include a cell transistor connected to a word line and a bit line and a cell capacitor connected to the cell transistor.

In this specification, a word line extending in a row direction may be referred to as a "row" of the first bank array 311_1. When accesses are repeatedly focused on a specific row, the row which is intensively accessed may be referred to as an "aggressor row". A row closest to the aggressor row may be referred to as a "victim row". A row which is adjacent to the aggressor row, with the victim row interposed therebetween, may be referred to as an "extended victim row".

For example, when the second word line WL2 is repeatedly accessed, the second row ROW2 corresponding to the second word line WL2 may be referred to as an "aggressor row", and the first and third rows ROW1 and ROW3 closest to the second row ROW2 may be referred to as a "victim row". Also, the 0-th and fourth rows ROW0 and ROW4 adjacent to the second row ROW2, with the victim rows interposed therebetween, may be referred to as an "extended victim row".

However, this is provided as an example. According to an embodiment, a victim row and an extended victim row may be variously set. For example, when the access to the fourth word line WL4 is focused, the fourth row ROW4 corresponding to the fourth word line WL4 may be referred to as an "aggressor row", and the second, third, fifth, and sixth rows closest to the fourth row ROW4 may be referred to as a "victim row", and the 0-th, first, seventh, and eighth rows adjacent to the fourth row ROW4, with the victim rows interposed therebetween, may be referred to as an "extended victim row". In other words, in some embodiments, there may be two victim rows between the aggressor row and the extended victim row. In some embodiments, there may be more than two victim rows between the aggressor row and the extended victim row.

Below, various examples of an operation method of a memory device supporting the row hammer refresh operation by using the RH register according to according to some embodiments, an operation method of a memory device supporting the extended row hammer refresh operation by using the ERH register according to according to an embodiment, and an operation method of a memory device supporting the extended row hammer refresh operation by using the ERH flag data according to according to an embodiment will be described in detail.

The operation method of the memory device supporting the row hammer refresh operation by using the RH register and the operation method of the memory device supporting the extended row hammer refresh operation by using the ERH register, which will be described below, are similar to each other. Thus, the same or similar description will be omitted to avoid redundancy, and the operation method using the ERH register will be mainly described.

### [Operation Method of Managing RH count Using Count Cell]

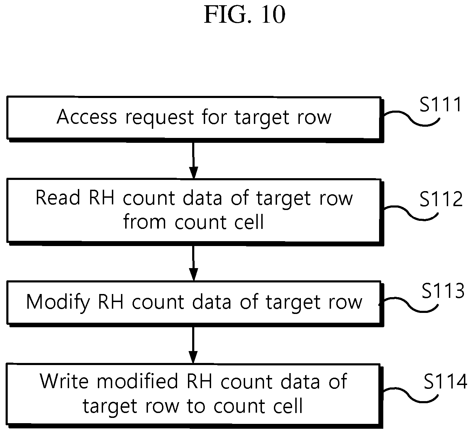

FIG. 10 is a diagram for describing an example of an operation of a memory device which manages RH count data through a count cell of a count cell area, according to an embodiment. A flowchart describing the read-write-modify (RMW) operation according to according to an embodiment is illustrated in FIG. 10 as an example. An operation method of a memory device to be described with reference to FIG. 10 may correspond, for example, to operation S11 of FIG. 2.

For convenience of description, in FIG. 10, it is assumed that the count cell area CCA includes a count cell and a parity cell and a target row is the first row ROW1 (refer to FIGS. 5 and 9) of the first bank array 311_1.

Referring to FIG. 10, in operation S111, the memory device may receive an access request for the target row.

For example, in an embodiment, the memory device 200 (refer to FIG. 4) may receive an address and an active command, which are associated with the first row ROW1 being the target row, from the memory controller 100 (refer to FIG. 4). In some embodiments, the memory device 200 may receive an address and a precharge command, which are associated with the first row ROW1 being the target row, from the memory controller 100.

In operation S112, the memory device 200 may read RH count data of the target row, which are stored in the count cell.

For example, the memory device 200 may read the RH count data from the count cell of the first row ROW1 of the first bank array 311_1.

In operation S113, the memory device 200 may modify the RH count data of the target row.

For example, the memory device 200 may generate the modified RH count data URHCD by adding "+1" to the RH count data.

In operation S114, the memory device 200 may write the modified RH count data URHCD to the count cell.

For example, the memory device 200 may store the modified RH count data URHCD to the count cell of the first row ROW1 of the first bank array 311_1. In other words, the memory device 200 may again store the modified RH count data URHCD to the count cell of the first row ROW1 to replace previously stored RH count data URHCD in the count cell of the first row ROW1.

As described above, the memory device 200 according to according to an embodiment may accurately manage RH count data for each row through a count cell of the count cell area CCA.

### [Method of Managing Relatively Large RH Count Data Using RH Register]

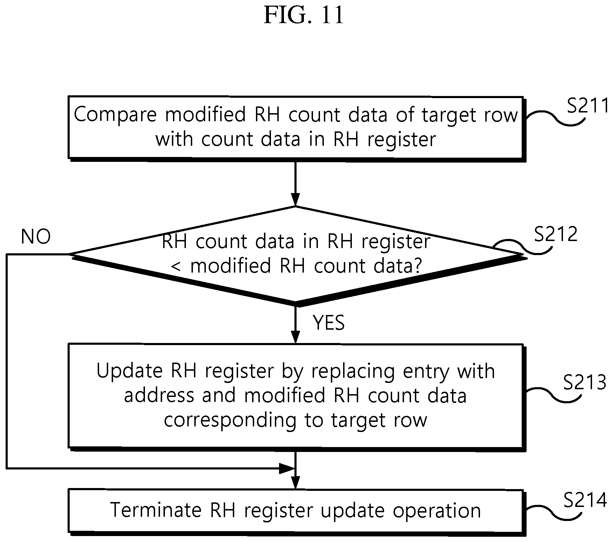

FIG. 11 is a flowchart for describing an example of an operation of a memory device which manages relatively large RH count data by using an RH register, according to an embodiment. An operation method of a memory device to be described with reference to FIG. 11 may correspond, for example, to operation S12 of FIG. 2.

Referring to FIG. 11, in operation S211, the memory device 200 may compare modified RH count data of a target row with RH count data managed in the RH register.

In operation S212, the memory device 200 may determine whether the RH count data of the RH register are less than the modified RH count data of the target row.

When the RH count data of the RH register are less than the modified RH count data of the target row, operation S213 may be performed. In operation S213, the memory device 200 may update the RH register by replacing an entry, which has a count less than the modified RH count data, from among entries of the RH register, with the address and the modified RH count data of the target row. Then, in operation S214, the RH register update operation may be terminated.

When the RH count data of the RH register are greater than or equal to the modified RH count data of the target row, operation S214 may be performed and the RH register update operation of operation S213 may not be performed.

In operation S214, the RH register update operation may be terminated.

As described above, the memory device according to according to an embodiment may manage a row with relatively large RH count data by using the RH register, based on a comparison result of modified RH count data and RH count data managed in the RH register. Accordingly, the row hammer refresh operation may be effectively performed.

### [Execution of Row Hammer Refresh Operation Based on RH Register]

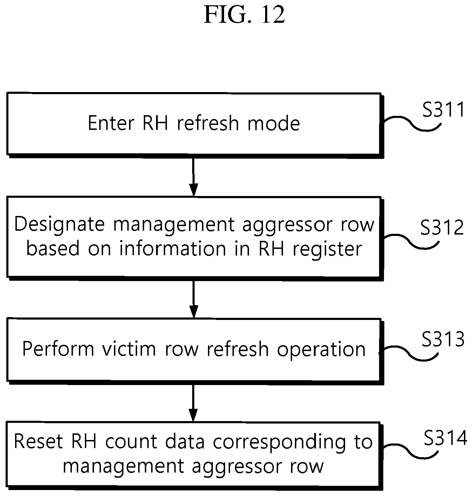

FIGS. 12 is a flowchart for describing an example of an operation of a memory device which performs a row hammer refresh operation based on information of a row managed in a RH register, according to an embodiment. An operation method of a memory device to be described with reference to FIG. 12 may correspond, for example, to operation S20 of FIG. 2.

Referring to FIG. 12, in operation S311, the memory device 200 may enter the row hammer refresh mode.

For example, in an embodiment, the memory device 200 may enter the row hammer refresh mode in response to an RFM command received from a memory controller. In some embodiments, when the memory device 200 is in the idle state or the background operation is performed, the memory device may enter the row hammer refresh mode. In some embodiments, before or after the normal refresh operation is performed, the memory device 200 may enter the row hammer refresh mode.

In operation S312, the memory device 200 may designate a management aggressor row, based on information in the RH register. For example, the memory device 200 may designate the management aggressor row, based on the information of a row managed in the RH register. For example, the memory device 200 may designate a row having the maximum RH count data from among rows managed in the RH register as the management aggressor row.

In operation S313, the memory device 200 may perform the victim row refresh operation on a victim row. For example, the memory device 200 may designate at least one row closest to the management aggressor row as a victim row and may perform the refresh operation on the victim row.

In this case, the victim row may be variously set. For example, as described with reference to FIG. 9, when the second ROW2 is designated as a management aggressor row, the first and third rows ROW1 and ROW3 adjacent to the second row ROW2 may be selected as victim rows.

In operation S314, the memory device 200 may reset the RH count data corresponding to the management aggressor row. For example, in association with the management aggressor row, the memory device 200 may reset both the RH count data of the count cell of the count cell area and the count RH data of the RH register to "0".

As described above, the memory device according to according to an embodiment may manage a row having relatively large RH count data from among a plurality of rows by using the RH register and may perform the row hammer refresh operation based on row information of the RH register. Accordingly, the memory device may manage the risk of occurrence of the row hammer phenomenon for each row to be an appropriate level or lower. This structural configuration and operation may mean that the row hammer phenomenon is effectively prevented.

### [First Operation Method of Managing ERH Count Using Extended Count Cell]

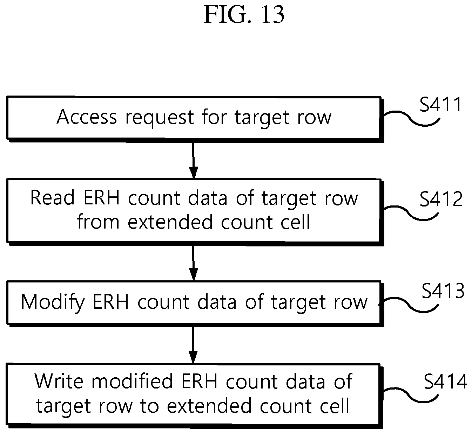

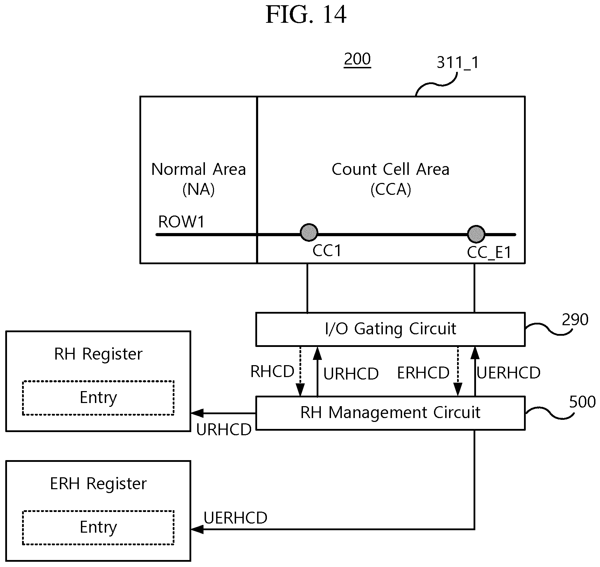

FIGS. 13 and 14 are diagrams for describing an example of an operation of a memory device which manages ERH count data through an extended count cell, according to an embodiment. In detail, a flowchart describing the read-write-modify (RMW) operation on the ERH count data according to according to an embodiment is illustrated in FIG. 13 as an example. An example of a memory device which performs the RMW operation on the ERH count data according to according to an embodiment is illustrated in FIG. 14. The memory device illustrated in FIGS. 13 and 14 may correspond to the memory device illustrated in FIGS. 1A, 1B, and 4. The operation method of the memory device to be described with reference to FIGS. 13 and 14 may correspond, for example, to operation S31 of FIG. 3A.

For convenience of description, in FIG. 14, it is assumed that the count cell area CCA includes a count cell and an extended count cell and a target row is the first row ROW1 of the first bank array 311_1.

Referring to FIGS. 13 and 14, in operation S411, the memory device 200 may receive an access request for the target row.

For example, in an embodiment, the memory device 200 (refer to FIG. 4) may receive an address and an active command, which are associated with the first row ROW1 being the target row, from the memory controller 100 (refer to FIG. 4). In some embodiments, the memory device 200 may receive an address and a precharge command, which are associated with the first row ROW1 being the target row, from the memory controller 100.

In operation S412, the memory device 200 may read ERH count data of the target row from the extended count cell.

For example, as illustrated in FIG. 14, the count cell area CCA of the first bank array 311_1 may include the first extended count cell CC_E1 and the first count cell CC1. In this case, in some embodiments, the ERH count data ERHCD stored in the first extended count cell CC_E1 and the RH count data RHCD stored in the first count cell CC1 may be read at the same time. Afterwards, the ERH count data ERHCD and the RH count data RHCD may be transferred to the row hammer management circuit 500 through the input/output gating circuit 290.

However, this is provided as an example. In some embodiments, the ERH count data ERHCD stored in the first extended count cell CC_E1 and the RH count data RHCD stored in the first count cell CC1 may be read independently of each other.

In operation S413, the memory device 200 may modify the ERH count data of the target row.

For example, as illustrated in FIG. 14, in some embodiments the row hammer management circuit 500 may generate the modified ERH count data UERHCD by adding "+1" to the ERH count data ERHCD. However, this is provided as an example. In some embodiments, the row hammer management circuit 500 may generate the modified ERH count data UERHCD by changing the ERH count data ERHCD in various manners.

The row hammer management circuit 500 may generate the modified RH count data RHCD by adding "+1" to the RH count data RHCD.

In operation S414, the memory device 200 may write the modified ERH count data URHCD to the extended count cell.

For example, as illustrated in FIG. 14, the row hammer management circuit 500 may write the modified ERH count data UERHCD and the modified RH count data URHCD respectively in the first extended count cell CC_E1 and the first count cell CC1, respectively, through the input/output (I/O) gating circuit 290.

As described above, the memory device 200 may accurately manage ERH count data for each row through the extended count cell of the count cell area CCA. In this case, the memory device 200 may manage RH count data for each row together through the count cell belonging to the same row.

As illustrated in FIG. 14, the row hammer management circuit 500 may transfer the modified ERH count data UERHCD to the ERH register corresponding to the first bank array 311_1. For example, when ERH count data of one of entries of the ERH register is less than the modified ERH count data UERHCD thus transferred, the corresponding entry of the ERH register may be replaced with the address and the modified ERH count data UERHCD of the target row. Accordingly, an address and ERH count data of a row having relatively large ERH count data from among a plurality of rows of managed in the count cell area CCA may be managed in the ERH register. This structural configuration and operation may mean that the extended row hammer refresh operation is effectively performed.

As illustrated in FIG. 14, the row hammer management circuit 500 may transfer the modified RH count data URHCD to the RH register corresponding to the first bank array 311_1. The RH register may manage an address and RH count data of a row having relatively large RH count data from among a plurality of rows of managed in the count cell area CCA. This structural configuration and operation may mean that the row hammer refresh operation is effectively performed.

### [Second Operation Method of Managing ERH Count Using Extended Count Cell]

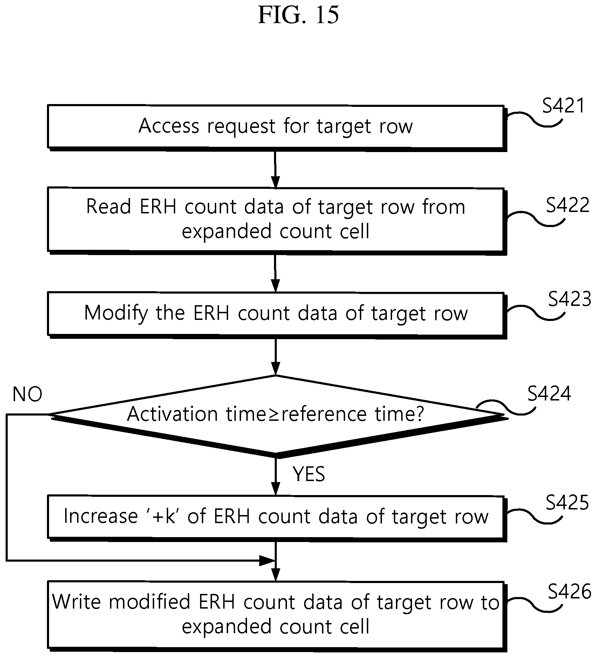

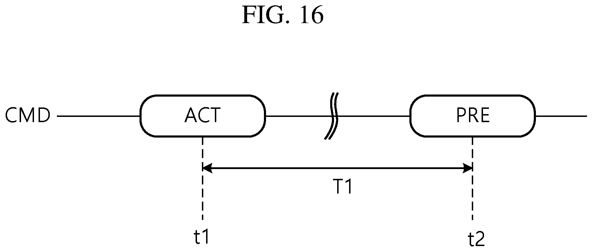

FIGS. 15 and 16 are diagrams for describing an example of an operation of a memory device which manages ERH count data through an extended count cell, according to an embodiment. In detail, a flowchart describing the read-modify-write (RMW) operation on the ERH count data according to according to an embodiment is illustrated in FIG. 15 as an example. A diagram for describing an activation time of a target row is illustrated in FIG. 16 as an example. An operation method of a memory device to be described with reference to FIGS. 15 and 16 may correspond, for example, to operation S31 of FIG. 3A. The operation of the memory device to be described with reference to FIGS. 15 and 16 is similar to that of FIGS. 13 and 14, and thus, additional description will be omitted to avoid redundancy.

In operation S421, the memory device 200 may receive the access request for the target row.

In operation S422, the memory device 200 may read ERH count data of the target row from the extended count cell. In some embodiments, the memory device 200 may read RH count data of the target row, which is stored in the count cell, together with the ERH count data.

In operation S423, the memory device 200 may modify the ERH count data of the target row. For example, the memory device 200 may modify the ERH count data of the target row in consideration of the number of times the target row has been activated. For example, the memory device may modify the ERH count data by increasing the ERH count data of the target row as much as "+1". In some embodiments, the memory device may modify the RH count data of the target row together in consideration of the number of times the target row has been activated.

In operation S424, the memory device 200 may determine whether the activation time of the target row is greater than or equal to a reference time.

For example, as illustrated in FIG. 16, a time T1 from a first point in time t1 when an active command ACT is received to a second point in time t2 when a precharge command PRE is received may be defined as the activation time. As the activation time becomes longer, the probability that data of an extended victim row and/or a victim row are lost due to a pass gate effect (PGE) phenomenon may increase. To suppress the PGE phenomenon, the memory device may determine whether the activation time T1 of the target row is greater than or equal to the reference time.

When the activation time of the target row is greater than or equal to the reference time, operation S425 may be performed. In operation S425, the memory device 200 may additionally modify the ERH count data of the target row in consideration of the activation time of the target row. For example, the memory device may modify the ERH count data by additionally increasing the ERH count data of the target row as much as "+k" (k being a natural number of 1 or more). In some embodiments, the memory device may additionally increase the RH count data of the target row as much as "+k" (k being a natural number of 1 or more). Then, in operation S426, the memory device 200 may write the modified ERH count data (i.e., that has been additionally increased) to the extended count cell. In some embodiments, the memory device 200 may perform the operation of writing the modified RH count data to the count cell together with writing the modified ERH count data to the extended count cell.

When the activation time of the target row is less than the reference time, operation S426 may be performed and operation S425 may be omitted.

In operation S426, the memory device 200 may write the modified ERH count data to the extended count cell. In some embodiments, the memory device 200 may perform the operation of writing the modified RH count data to the count cell together with writing the modified ERH count data to the extended count cell.

As described above, the memory device 200 may manage ERH count data for each row through the extended count cell. The memory device 200 may modify the ERH count data in consideration of the activation time, in addition to the number of times of access of each of the plurality of rows. Accordingly, the probability that the data stored at the extended victim row are lost may further decrease.

### [First Method of Managing Relatively Large ERH Count Using ERH Register]

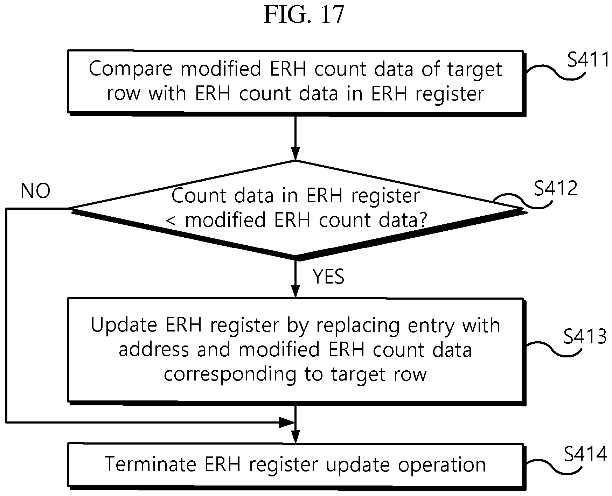

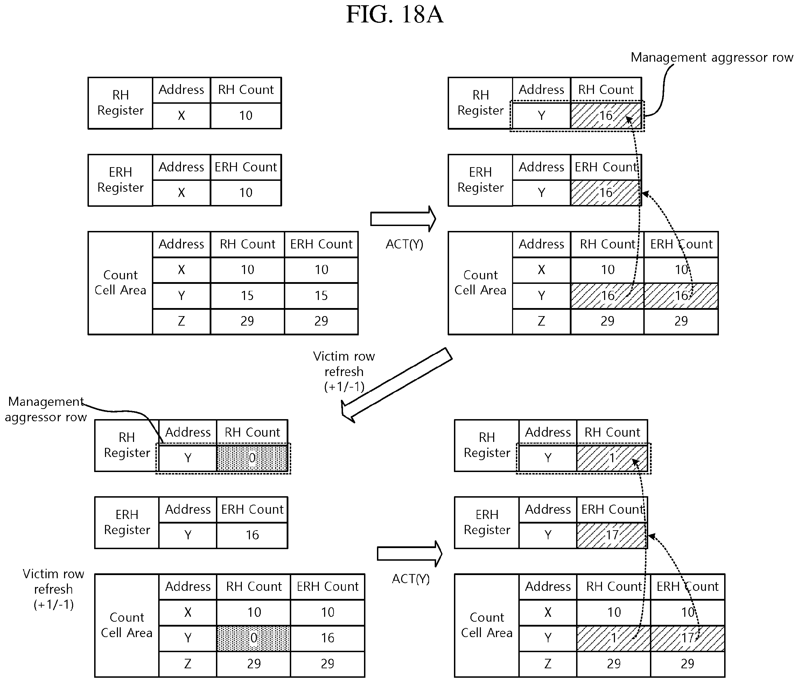

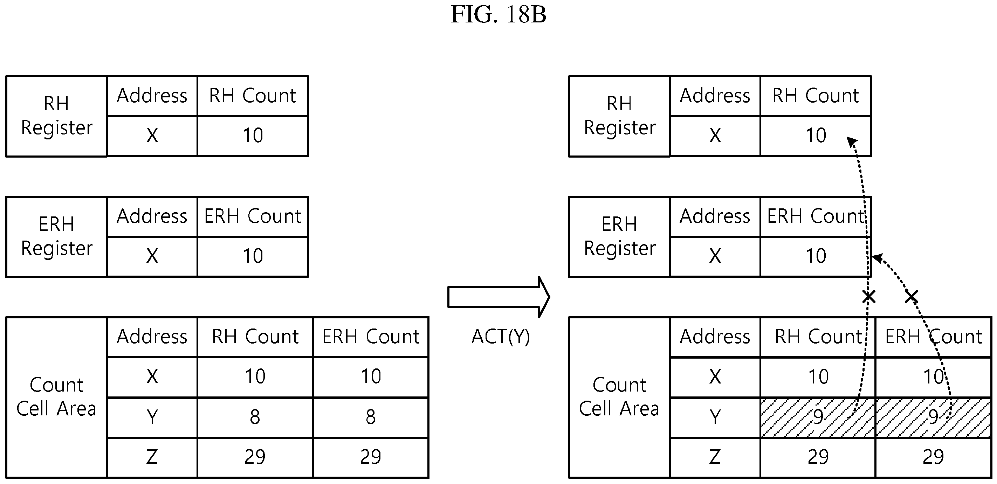

FIGS. 17, 18A, and 18B are diagrams for describing an example of an operation of a memory device which manages relatively large ERH count data by using an ERH register, according to an embodiment. In detail, a flowchart describing an ERH register update operation according to according to an embodiment is illustrated in FIG. 17 as an example. The case where modified ERH count data is greater than ERH count data of the ERH register is illustrated in FIG. 18A as an example. The case where modified ERH count data is less than ERH count data of the ERH register is illustrated in FIG. 18B as an example. An operation method of a memory device to be described with reference to FIGS. 17, 18A, and 18B may correspond, for example, to operation S32 of FIG. 3A.

For convenience of description, in FIGS. 18A and 18B, it is assumed that each of the ERH register and the RH register manages one entry. Also, it is assumed that a target row corresponding to address "Y" is activated. In addition, in FIG. 18A, it is assumed that the row hammer refresh operation is performed once.

Referring to FIGS. 17, 18A, and 18B, in operation S411, the memory device 200 may compare modified ERH count data of the target row with ERH count data in the ERH register.

In operation S412, the memory device 200 may determine whether the ERH count data of the ERH register is less than the modified ERH count data of the target row.

When the ERH count data of the ERH register is less than the modified ERH count data of the target row, operation S413 may be performed.

In operation S413, the memory device may replace an entry, which includes ERH count data less than the modified ERH count data, from among entries of the ERH register with the address and the modified ERH count data of the target row. Accordingly, the ERH register may be updated. In operation S414, the ERH register update operation may be terminated.

In an embodiment, the description will be given in detail with reference to FIG. 18A. It is assumed that rows corresponding to address "X", address "Y", and address "Z" are managed in the count cell area and RH count data and ERH count data of address "X", address "Y", and address "Z" are "10", "15", and "29", respectively. Also, it is assumed that the row corresponding to address "X" is managed in the ERH register and the ERH count data of the row of address "X" are "10". Also, it is assumed that the row corresponding to address "X" is managed in the RH register and the RH count data of the row of address "X" are "10".

Afterwards, it is assumed that an address of a target row is "Y" when an active command ACT(Y) for the target row is received.

In this case, the memory device 200 may modify the ERH count data and the RH count data of the count cell area through the read-modify-write (RMW) operation. For example, the memory device 200 may modify the ERH count data and the RH count data of the row corresponding to address "Y" from "15" to "16", respectively.

Afterwards, the memory device 200 may determine whether the ERH count data of an entry managed in the ERH register is less than the modified ERH count data. Because the ERH count data (i.e., "10") of the ERH register (in this case the ERH count data of the ERH register of the row corresponding to address "X") is less than the modified ERH count data (i.e., "16"), the address and the ERH count data being the entry of the ERH register may be replaced with address "Y" being the address of the target row and "16" being the modified ERH count data. As in the above description, the address and the RH count data of the entry of the RH register may be replaced with address "Y" being the address of the target row and "16" being the modified ERH count data.

Afterwards, it is assumed that the row hammer refresh operation is performed. In this case, the row hammer refresh operation may be performed based on the RH register, the address of the management aggressor row may be "Y", and addresses of victim rows may be "Y-1" and "Y+1".

When the row hammer refresh operation is performed, as illustrated in FIG. 18A, in association with the management aggressor row, both the RH count data of the count cell area and the RH count data of the RH register may be reset to "0".

Afterwards, it is assumed that an active command ACT(Y) for a target row is received and an address of the target row is "Y".

In this case, the memory device 200 may modify the ERH count data and the RH count data of the count cell area through the RMW operation. For example, the memory device 200 may modify the ERH count data of the row corresponding to address "Y" from "16" to "17". Also, the memory device 200 may modify the RH count data of the count cell area of the row corresponding to address "Y" from "0" to "1".

Afterwards, the memory device 200 may determine whether ERH count data of an entry managed in the ERH register is less than the modified ERH count data. Because the count data (i.e., "16") of the ERH register is less than the modified ERH count data (i.e., "17"), the ERH count data of the ERH register may be modified to "17". In this case, because addresses before and after the modification are identical, that is, "Y", the address of the entry of the ERH register may be maintained with "Y". As in the above description, the RH register of the entry of the RH register may be modified to "1".

Continuing to refer to FIG. 17, when the ERH count data of the ERH register is greater than or equal to the modified ERH count data of the target row, the ERH register update operation may be omitted.

In an embodiment, the description will be given in detail with reference to FIG. 18B. Unlike FIG. 18A, it is assumed that each of the RH count data and the ERH count data of address "Y" managed in the count cell area is "8". Afterwards, it is assumed that an active command ACT(Y) for a target row is received and an address of the target row is "Y".

In this case, the memory device 200 may modify the ERH count data of the count cell area, which correspond to the row corresponding to address "Y", from "8" to "9" through the RMW operation. Afterwards, the memory device 200 may determine whether ERH count data of an entry managed in the ERH register is less than modified ERH count data. Because the ERH count data (i.e., "10") of the ERH register (in this case the ERH count data of the ERH register of the row corresponding to address "X") is greater than the modified ERH count data (i.e., "9"), the entry of the ERH register may not be replaced, that is, may be maintained without replacement. As in the above description, the memory device 200 may modify the RH count data of the count cell area from "8" to "9", and the entry of the RH register may be maintained without replacement.

In operation S414, the ERH register update operation may be terminated.

As described above, the memory device 200 may manage a row with relatively large ERH count data by using the ERH register, based on a comparison result of modified ERH count data and ERH count data managed in the ERH register. Accordingly, the extended row hammer refresh operation may be effectively performed.

### [Second Method of Managing Relatively Large ERH Count Using ERH Register]

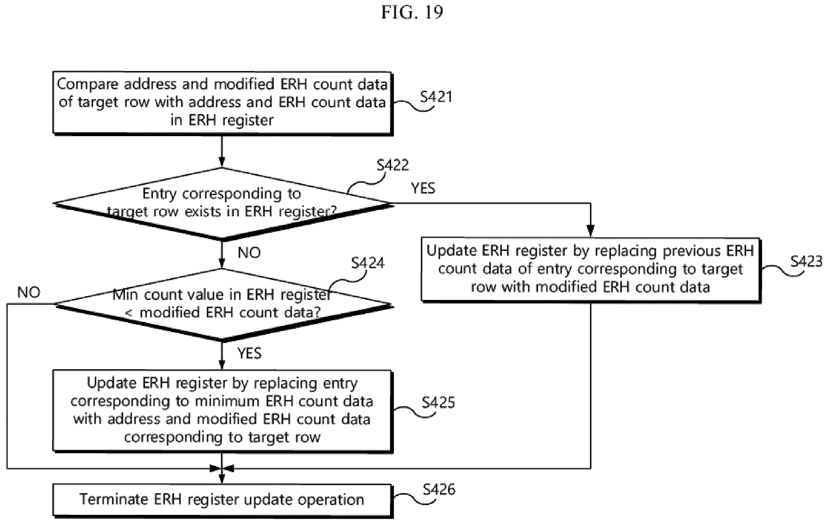

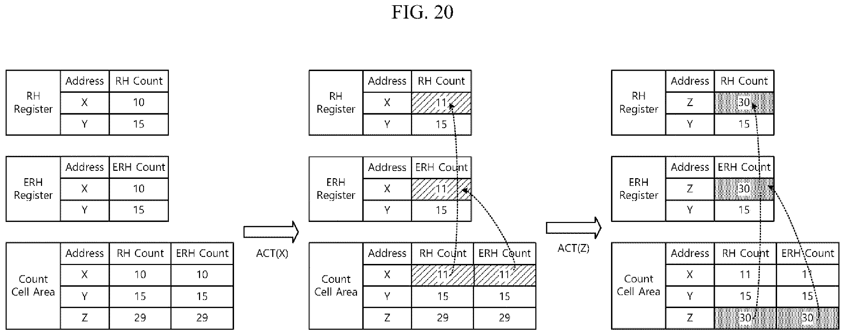

FIGS. 19 and 20 are diagrams for describing an example of an operation of a memory device which manages relatively large ERH count data by using an ERH count data register, according to an embodiment. In detail, a flowchart describing the ERH register update operation according to according to an embodiment is illustrated in FIG. 19 as an example. The case where an address corresponding to modified ERH count data is already present in an entry of the ERH register and the case where an address corresponding to modified count data is absent from an entry of the ERH register are illustrated in FIG. 20 as an example. An operation method of a memory device to be described with reference to FIG. 20 may correspond, for example, to operation S32 of FIG. 3A.

For convenience of description, in FIG. 19, it is assumed that each of the ERH register and the RH register manages two entries. Also, as in the above description given with reference to FIG. 18A, it is assumed that rows corresponding to address "X", address "Y", and address "Z" are managed in the count cell area and ERH count data and the RH count data of address "X", address "Y", and address "Z" are "10", "15", and "29", respectively. Also, it is it is assumed that the rows corresponding to address "X" and address "Y" are managed in the ERH register and the RH register and count data of the rows corresponding to address "X" and address "Y" are "10" and "15". Afterwards, it is assumed that a target row corresponding to address "X" is activated and a target row corresponding to address "Z" is then activated. An operation of the memory device to be described with reference to FIGS. 19 and 20 is similar to that described with reference to FIGS. 17 and 18, and thus, additional description will be omitted to avoid redundancy.

Referring to FIGS. 19 and 20, in operation S421, the memory device 200 may compare an address and modified ERH count data of the target row with an address and ERH count data managed in the ERH register.

In operation S422, the memory device 200 may determine whether an entry corresponding to the target row from among entries managed in the ERH register exists. When the entry corresponding to the target row from among the entries managed in the ERH register exists, operation S423 may be performed. When the entry corresponding to the target row from among the entries managed in the ERH register does not exist, operation S424 may be performed.

In operation S423, the memory device 200 may update the ERH register by replacing previous ERH count data of the target row managed in the entry of the ERH register with modified ERH count data. Then, operation S426 may be performed and the ERH register update operation may be terminated.

In an embodiment, the description will be given in detail with reference to FIG. 20. It is assumed that an active command ACT(X) for the target row is received and an address of the target row is "X".

In this case, the memory device 200 may modify the ERH count data count data of the row corresponding to address "X" from "10" to "11" through the RMW operation. Afterwards, the memory device 200 may determine whether address "X" is managed in the ERH register. Because address "X" is managed in the ERH register, the memory device may replace the ERH count data of the ERH register corresponding to address "X", that is, "10" being the previous ERH count data with "11" being newly modified ERH count data.

As in the above description, the memory device 200 may modify the RH count data of the row corresponding to address "X" from "10" to "11" in the count cell area and may modify the RH count data of the row corresponding to address "X" from "10" to "11" in the RH register.

In operation S424, the memory device 200 may determine whether the minimum ERH count data among pieces of count data of the ERH register is less than the modified ERH count data of the target row.

When the minimum ERH count data among pieces of ERH count data of the ERH register is less than the modified ERH count data of the target row, operation S425 may be performed.

In operation S425, the memory device may update the ERH register by replacing the entry of the register, which has the minimum ERH count data, with the address and the modified ERH count data of the target row.

In one example, when the modified extended row hammer count data corresponding to the target row is greater than a minimum extended row hammer count data among extended row hammer count data stored in the second register, the row hammer management circuit replaces an entry of the second register corresponding to the minimum extended row hammer count data with the address and the modified extended row hammer count data of the target row.

In an embodiment, the description will be given in detail with reference to FIG. 20. It is assumed that an active command ACT(Z) for a target row is received and an address of the target row is "Z".

In this case, the memory device 200 may modify the ERH count data of the count cell area, which correspond to the row corresponding to address "Z", from "29" to "30" through the RMW operation. Afterwards, the memory device 200 may determine whether the minimum ERH count data among pieces of ERH count data of entries managed in the ERH register is less than the modified ERH count data. Because the minimum ERH count data (i.e., ‴11") of the ERH register is less than the modified ERH count data (i.e., "30"), address "X" of the entry of the ERH register and the ERH count data of "1 1" corresponding to address "X" may be replaced with address "Z" of the target row and the ERH count data of "30" corresponding to address "Z". As in the above description, address "X" and the RH count data of "1 1" constituting the entry of the RH register may be replaced with address "Z" of the target row and "30" being the ERH count data corresponding to address "Z".

Continuing to refer to FIG. 19, when the minimum ERH count data among the pieces of ERH count data of the ERH register is greater than or equal to the modified ERH count data of the target row, the ERH register update operation (i.e., operation S425) may be omitted.

In operation S426, the ERH register update operation may be terminated.

As described above, the memory device 200 may update previous ERH count data when an address corresponding to the modified ERH count data is already present in an entry of the ERH register. When the address corresponding to the modified ERH count data is absent from the entries of the ERH register, the memory device 200 may replace an entry of the ERH register corresponding to the minimum ERH count data with the address and the modified ERH count data of the target row. Since the memory device 200 manages a row with relatively large ERH count data by using the ERH register, the extended row hammer refresh operation may be effectively performed.

### [Third Method of Managing Relatively Large ERH Count Using ERH Register]

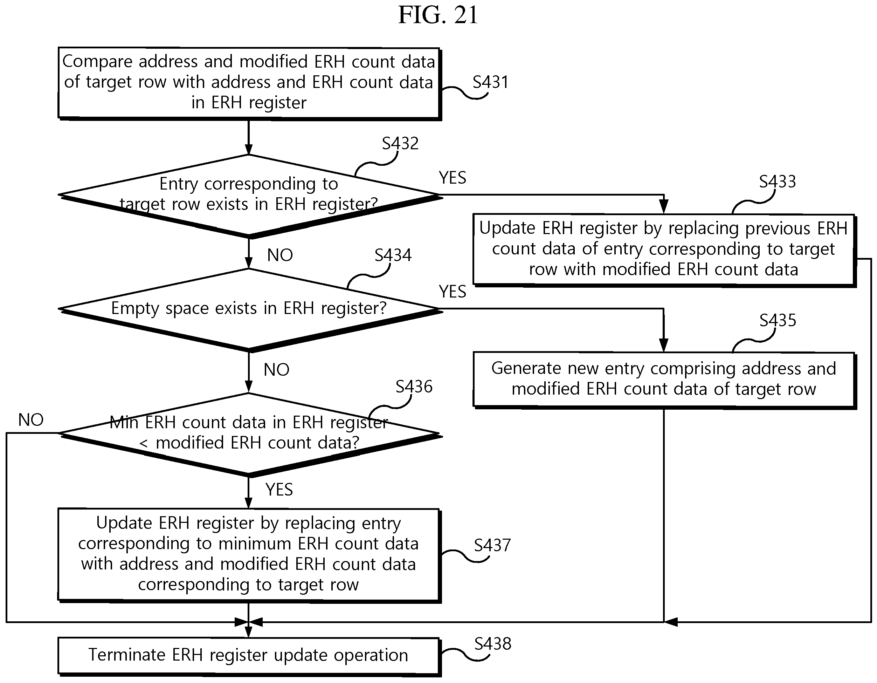

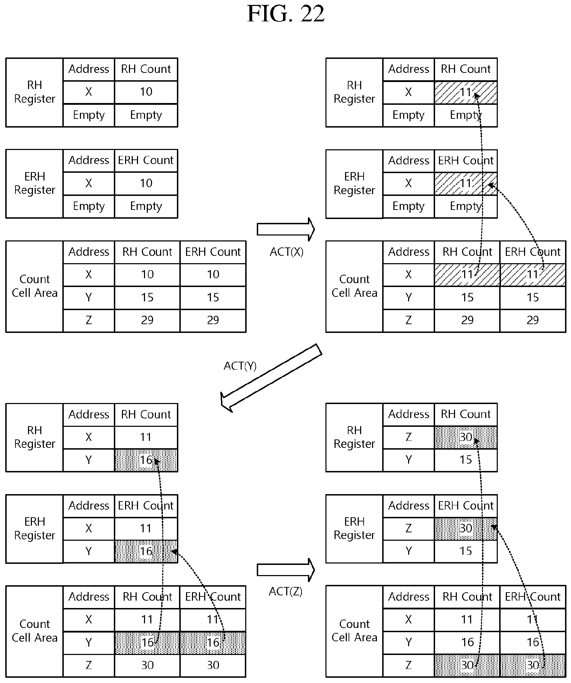

FIGS. 21 and 22 are diagrams for describing an example of an operation of a memory device which manages relatively large ERH count data by using an ERH register, according to an embodiment. In detail, a flowchart describing the ERH register update operation according to an embodiment is illustrated in FIG. 21 as an example. The case where an empty space is present in the ERH register and the case where an empty space is absent from the ERH register are illustrated in FIG. 22 an example. An operation method of a memory device to be described with reference to FIGS. 21 and 22 may correspond, for example, to operation S32 of FIG. 3A.

For convenience of description, in FIG. 22, it is assumed that the register manages two entries. Also, as in the above description given with reference to FIG. 18A, it is assumed that rows corresponding to address "X", address "Y", and address "Z" are managed in the count cell area and ERH count data and RH count data of address "X", address "Y", and address "Z" are "10", "15", and "29", respectively. Also, it is assumed that the row corresponding to address "X" is managed in the ERH register and the RH register. Afterwards, it is assumed that the rows corresponding to address "X", address "Y", and address "Z" are sequentially activated. An operation of a memory device to be described with reference to FIGS. 21 and 22 is similar to that described with reference to FIGS. 19 and 20, and thus, additional description will be omitted to avoid redundancy.

Referring to FIGS. 21 and 22, in operation S431, the memory device 200 may compare an address and modified ERH count data of a target row with an address and ERH count data managed in the ERH register.

In operation S432, the memory device may determine whether an entry corresponding to the target row from among entries managed in the ERH register exists.

When the entry corresponding to the target row from among the entries managed in the ERH register exists, operation S433 may be performed. In operation S433, the memory device 200 may update the ERH register by replacing previous ERH count data of the target row managed in the entry of the ERH register with modified ERH count data.

In an embodiment, the description will be given in detail with reference to FIG. 22. It is assumed that an active command ACT(X) for a target row is received and an address of the target row is "X".

In this case, the memory device 200 may modify the RH count data and the ERH count data of the row corresponding to address "X" from "10" to "11" through the RMW operation. Afterwards, the memory device may determine whether address "X" is managed in the ERH register. Because address "X" is managed in the ERH register, the memory device 200 may replace the ERH count data of the ERH register corresponding to address "X", that is, "10" being the previous ERH count data with "11" being the modified ERH count data. As in the above description, the memory device 200 may replace the RH count data of the RH register corresponding to address "X", that is, "10" being previous RH count data with "11" being the modified RH count data.

When the entry corresponding to the target row from among the entries managed in the ERH register does not exist, operation S434 may be performed.

In operation S434, the memory device 200 may determine whether an empty space is present in the ERH register. When an empty space is present in the ERH register, operation S435 may be performed. When an empty space is absent from the ERH register, operation S436 may be performed.

In operation S435, the memory device 200 may generate a new entry including the address and the modified ERH count data of the target row and may write the new entry to the ERH register.

In an embodiment, the description will be given in detail with reference to FIG. 22. It is assumed that an active command ACT(Y) for a target row is received and an address of the target row is "Y".

In this case, the memory device 200 may modify the RH count data and the ERH count data of the row corresponding to address "Y" from "15" to "16" through the RMW operation. Afterwards, the memory device 200 may determine whether address "Y" is managed in the ERH register. When address "Y" is not managed in the ERH register, the memory device 200 may determine whether an empty space is present in the ERH register. Because an empty space is present in the ERH register, the memory device 200 may generate a new entry including address "Y" and "16" being the ERH count data corresponding to address "Y", so as to be stored in the ERH register. As in the above description, the memory device 200 may generate a new entry including address "Y" and "16" being the RH count data corresponding to address "Y", so as to be stored in the RH register.

In operation S436, the memory device 200 may determine whether the minimum ERH count data among pieces of ERH count data of the ERH register is less than the modified ERH count data of the target row.

When the minimum ERH count data among the pieces of ERH count data of the ERH register is less than the modified ERH count data of the target row, operation S437 may be performed.

In operation S437, the memory device 200 may update the ERH register by replacing the entry of the ERH register, which has the minimum ERH count data, with the address and the modified ERH count data of the target row.

In an embodiment, the description will be given in detail with reference to FIG. 22. It is assumed that an active command ACT(Z) for a target row is received and an address of the target row is "Z".

In this case, the memory device 200 may modify the RH count data and the ERH count data of the row corresponding to address "Z" from "29" to "30" through the RMW operation. Afterwards, the memory device 200 may determine whether the minimum ERH count data among pieces of ERH count data of entries managed in the ERH register is less than the modified ERH count data, may replace address "X" of the entry of the ERH register with "Z" being the address of the target row, and may replace "11" being the ERH count data of address "X" with "30" being the modified ERH count data of the target row. As in the above description, the memory device 200 may replace address "X" of the entry of the RH register with "Z" being the address of the target row and may replace "11" being the RH count data of address "X" with "30" being the modified RH count data of the target row.

When the minimum ERH count data among the pieces of count data of the ERH register is greater than or equal to the modified ERH count data of the target row, the ERH register update operation (i.e., operation S437) may be omitted and operation S438 may be performed.

In operation S438, the ERH register update operation may be terminated.

As described above, the memory device 200 may update previous ERH count data when an address corresponding to the modified ERH count data is already present in an entry of the ERH register. When the address corresponding to the modified ERH count data is absent from entries of the ERH register and an empty space is present in the ERH register, the memory device 200 may generate an entry corresponding to the target row. When the address corresponding to the modified ERH count data is absent from entries of the ERH register and an empty space is absent from the ERH register, the memory device 200 may replace an entry of the ERH register corresponding to the minimum ERH count data with the address and the modified ERH count data of the target row.

Since the memory device 200 manages a row with relatively large ERH count data by using the ERH register, the extended row hammer refresh operation may be effectively performed.

### [Fourth Method of Managing Relatively Large ERH Count Using ERH Register]

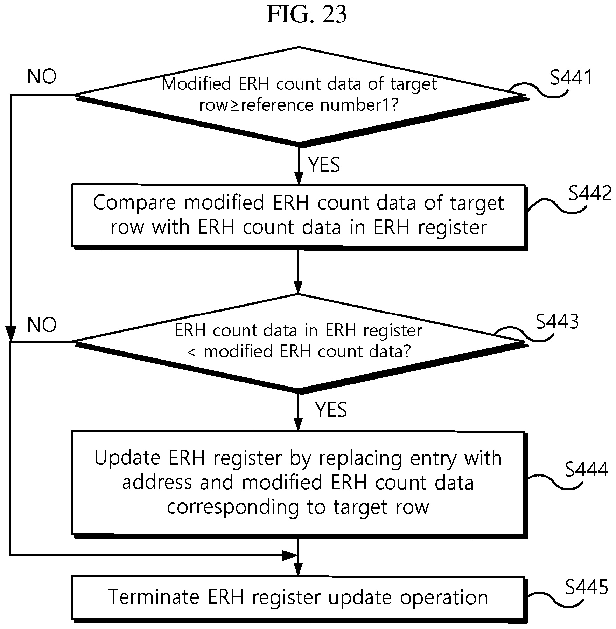

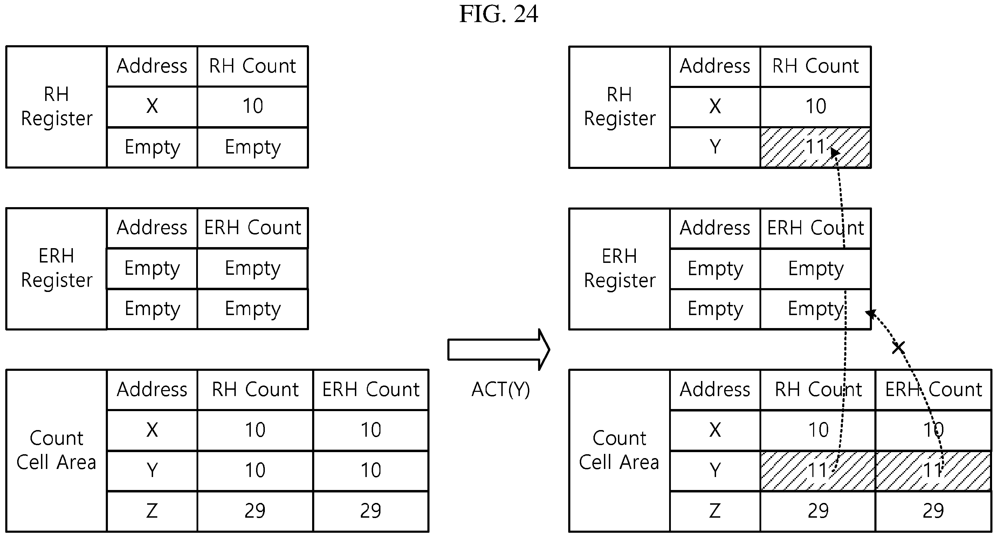

FIGS. 23 and 24 are diagrams for describing an example of an operation of a memory device which manages relatively large ERH count data by using an ERH register, according to an embodiment. In detail, a flowchart describing the ERH register update operation according to an embodiment is illustrated in FIG. 23 as an example. The case where modified ERH count data is less than a first reference number and modified RH count data is greater than a second reference number is illustrated in FIG. 24 as an example. An operation method of a memory device to be described with reference to FIGS. 23 and 24 may correspond, for example, to operation S32 of FIG. 3A.

For convenience of description, in FIG. 24, it is assumed that the register manages two entries. Also, it is assumed that rows corresponding to address "X", address "Y", and address "Z" are managed in the count cell area and RH count data and ERH count data of address "X", address "Y", and address "Z" are "10", "10", and "29", respectively. Also, it is assumed that the ERH register is empty and the row corresponding to address "X" is managed in the RH register. Afterwards, it is assumed that a target row corresponding to address "Y" is activated. An operation of a memory device to be described with reference to FIGS. 23 and 24 is similar to that described with reference to FIGS. 17 and 18, and thus, additional description will be omitted to avoid redundancy.

Referring to FIGS. 23 and 24, in operation S441, the memory device 200 may determine whether modified ERH count data of the target row is greater than the first reference number. In one example, the memory device 200 may determine whether modified ERH count data of the target row is greater or equal to than the first reference number.

When the modified ERH count data of the target row is less than the first reference number, the ERH register update operation may be omitted and operation S445 may be performed.

In an embodiment, the description will be given in detail with reference to FIG. 24. It is assumed that an active command ACT(Y) for a target row is received and an address of the target row is "Y". Also, it is assumed that the first reference number is "30" and the second reference number is "10". In an embodiment, the first reference number may be a threshold number for writing ERH count data to the ERH register. The second reference number may be a threshold number for writing RH count data to the RH register. In general, when the disturbance due to the extended row hammer phenomenon is less than the disturbance due to the row hammer phenomenon, the first reference number may be set to be greater than the second reference number.

In this case, the memory device 200 may modify RH count data and ERH count data of the row corresponding to address "Y" from "10" to "11" through the RMW operation.

Afterwards, the memory device 200 may determine whether the modified ERH count data are larger than the first reference number. Because the modified ERH count data (i.e., "11") is less than the first reference number (i.e., "30"), the memory device 200 may omit the operation of updating the ERH register by using the modified ERH count data. In other words, the modified ERH count data less than the first reference number may not be managed by the ERH register. Accordingly, the memory device may manage rows having ERH count data greater than the first reference number by using the ERH register.

As in the above description, the memory device 200 may determine whether the modified RH count data is greater than the second reference number. Because the modified RH count data (i.e., "11") is greater than the second reference number (i.e., "10"), the memory device 200 may update the RH register by using the modified RH count data.

As a result, only a row having ERH count data being greater than or equal to the first reference number may be managed in the ERH register, and only a row having RH count data being greater than or equal to the second reference number may be managed in the RH register. Because the first reference number is greater than the second reference number, the row hammer refresh operation which is performed based on the RH register may be performed more frequently than the extended row hammer refresh operation which is performed based on the ERH register. Accordingly, since magnitudes of the first reference number and the second reference number are differently set, the execution ratio of the row hammer refresh operation to the extended row hammer refresh operation may be adjusted.

Meanwhile, when the modified ERH count data of the target row is greater than or equal to the first reference number, operation S442 may be performed.

In operation S442, the memory device 200 may compare the modified ERH count data of the target row with the ERH count data managed in the ERH register.

In operation S443, the memory device 200 may determine whether the ERH count data of the ERH register is less than the modified ERH count data of the target row.

When the ERH count data of the ERH register is less than the modified ERH count data of the target row, the memory device 200 may replace an entry, which includes ERH count data less than the modified ERH count data, from among entries of the ERH register with the address and the modified ERH count data of the target row in operation S444. Accordingly, the ERH register may be updated.

When the ERH count data of the ERH register is greater than or equal to the modified ERH count data of the target row, the ERH register update operation (i.e., operation S444) may be omitted and operation S445 may be performed.

In operation S445, the ERH register update operation may be terminated.

As described above, the memory device 200 may manage a row with ERH count data being greater than or equal to the first reference number by using the ERH register, and a row with ERH count data less than the first reference number may not be managed in the ERH register. Also, the memory device 200 may adjust the execution ratio of the row hammer refresh operation to the extended row hammer refresh operation by adjusting magnitudes of the first reference number and the second reference number.

As described above, the memory device 200 may manage a row with relatively large ERH count data by using the ERH register, based on a comparison result of modified ERH count data and ERH count data managed in the ERH register. Accordingly, the extended row hammer refresh operation may be effectively performed.

### [First Operation of Performing Extended Row Hammer Refresh Operation Based on ERH Register]

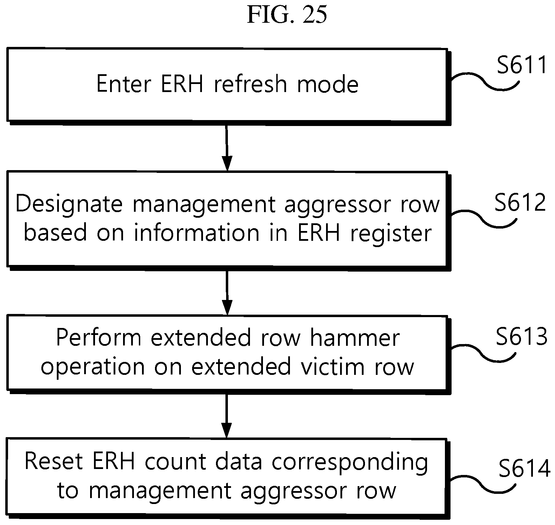

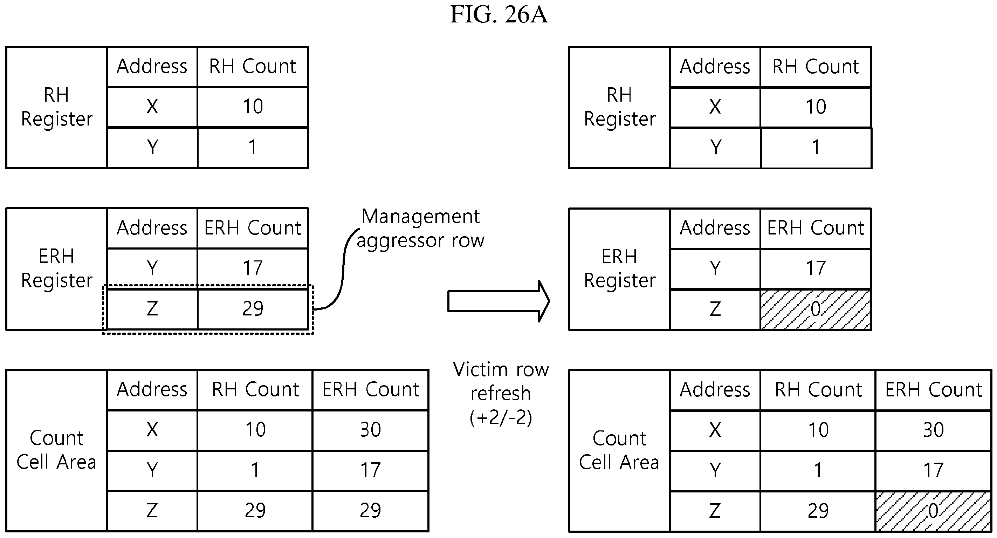

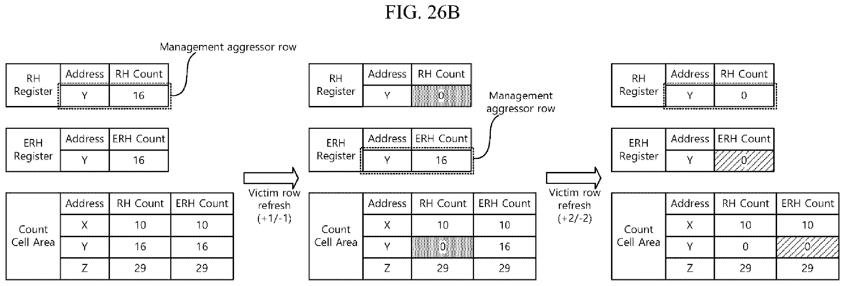

FIGS. 25, 26A, and 26B are diagrams for describing an example of an operation of a memory device which performs an extended row hammer refresh operation based on information of a row managed in an ERH count data register, according to an embodiment. In detail, a flowchart of the extended row hammer refresh operation according to an embodiment is illustrated in FIG. 25 as an example. An example in which the extended row hammer refresh operation is performed based on the ERH register is illustrated in FIG. 26A. An example in which the row hammer operation based on the RH register and the extended row hammer operation based on the ERH register are sequentially performed is illustrated in FIG. 26B. An operation method of a memory device to be described with reference to FIGS. 25, 26A, and 26B may correspond, for example, to operation S40 of FIG. 3A.

Referring to FIG. 25, in operation S611, the memory device 200 may enter the extended row hammer (ERH) refresh mode.

For example, in some embodiments, the memory device 200 may enter the ERH refresh mode in response to the RFM command received from a memory controller. In some embodiments, when the memory device is in the idle state or the background operation is performed, the memory device 200 may enter the ERH refresh mode. In some embodiments, before or after the normal refresh operation is performed, the memory device 200 may enter the ERH refresh mode.

In operation S612, the memory device 200 may designate a management aggressor row, based on information of a row managed in the ERH register. For example, the memory device 200 may designate at least one row having the maximum ERH count data from among rows managed in the ERH register as a management aggressor row.

For example, referring to FIG. 26A, rows corresponding to address "Z" and address "Y" are managed in the ERH register, ERH count data of address "Z" are "29", and ERH count data of address "Y" are "17". In this case, the memory device 200 may designate the row, which has the maximum ERH count data and corresponds to address "Z", from among the rows managed in the ERH register as a management aggressor row.

In operation S613, the memory device 200 may perform the extended row hammer refresh operation on an extended victim row. For example, when an address of the management aggressor row is "Z", the memory device 200 may designate each of a row whose address is "Z+2" and a row whose address is "Z-2" as an extended victim row and may sequentially perform the refresh operations on the extended victim rows.

In operation S614, the memory device 200 may reset the ERH count data corresponding to the management aggressor row. For example, in association with the management aggressor row, the memory device 200 may reset both the ERH count data of the count cell area and the ERH count data of the ERH register to "0".

For example, referring to FIG. 26A, the count data corresponding to address "Z" designated as the management aggressor row may be reset to "0" in both the count cell area and the ERH register.

In FIG. 26A, a row having the maximum ERH count data in the count cell area corresponds to address "X", but the row corresponding to address "X" may not be managed in the ERH register. This situation means that the row corresponding to address "X" is not accessed any more during a given time from a current time point. Accordingly, the risk of occurrence of the extended row hammer on the row corresponding to address "X" is not increased any more, that is, is continuously maintained. As a result, an upper bound of the row hammer disturb may be set for each extended row.

In FIGS. 25 and 26A, the description is given as only the extended row hammer refresh operation is performed in the ERH refresh mode. However, this is provided as an example, and embodiments are not limited thereto. In some embodiments, in the ERH refresh mode, both the row refresh operation and the extended row hammer refresh operation may be performed.

The description will be given in detail with reference to FIG. 26B. In the ERH refresh mode, the row refresh operation and the extended row hammer refresh operation may be sequentially performed.

In this case, a row whose address is "Y" may be designated as a management aggressor row, and a row whose address is "Y+1" and a row whose address is "Y-1" may be designated as a victim row. Afterwards, the refresh operations on the victim rows may be performed, and both the RH count data of the count cell area and the RH count data of the RH register may be reset to "0" in association with the management aggressor row. Afterwards, a row whose address is "Y" may be designated as a management aggressor row based on the ERH register, and a row whose address is "Y+2" and a row whose address is "Y-2" may be designated as an extended victim row. Afterwards, the refresh operations on the extended victim rows may be performed, and both the ERH count data of the count cell area and the ERH count data of the ERH register may be reset "0" in association with the management aggressor row.

As described above, the memory device 200 may manage a row having relatively large ERH count data from among a plurality of rows by using the ERH register and may perform the extended row hammer refresh operation based on row information of the ERH register. Accordingly, the memory device 200 may manage the risk of occurrence of the row hammer phenomenon for each row to be an appropriate level or lower. This structural configuration and operation may mean that the extended row hammer phenomenon is effectively prevented.

The description given with reference to FIGS. 25, 26A, and 26B as a row having the maximum ERH count data from among rows under management is designated as a management aggressor row is provided as an example for convenience of description, but embodiments are not limited thereto. That is, in operation S612, the memory device 200 may designate a plurality of rows having the maximum ERH count data from among rows managed in the ERH register as management aggressor rows. In this case, in operation S613 and operation S614, the memory device 200 may perform the extended row hammer refresh operations on the rows designated as the management aggressor rows and may reset the ERH count data corresponding to the management aggressor rows.

For example, the memory device 200 may designate two rows having the first and second maximum ERH count data from among rows managed in the ERH register as management aggressor rows. In this case, in operation S613, the memory device 200 may perform the extended row hammer refresh operations on the rows designated as the management aggressor rows; in operation S614, the memory device 200 may reset the ERH count data corresponding to the two rows designated as the management aggressor rows.

### [Second Operation of Performing Extended Row Hammer Refresh Operation Based on ERH Register]

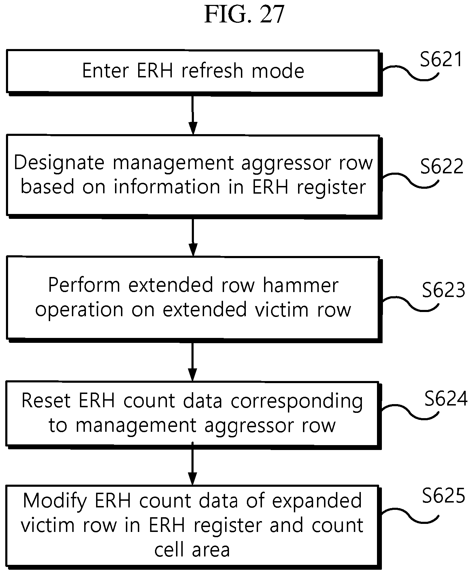

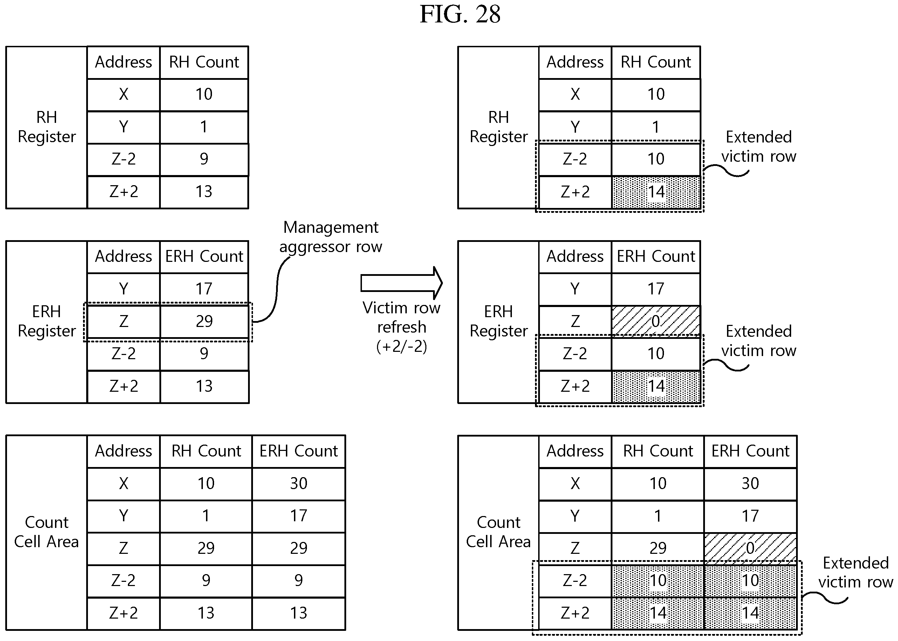

FIGS. 27 and 28 are diagrams for describing an example of an operation of a memory device which performs an extended row hammer refresh operation based on information of a row managed in an ERH register, according to an embodiment. In detail, a flowchart of the extended row hammer refresh operation according to an embodiment is illustrated in FIG. 27 as an example. An example in which ERH count data and RH count data of an extended victim row are modified is illustrated in FIG. 28. An operation method of a memory device to be described with reference to FIGS. 27 and 28 may correspond, for example, to operation S40 of FIG. 3A.

For convenience of description, it is assumed that rows corresponding to address "X", address "Y", address "Z", address "Z-2", and address "Z+2" are managed in the count cell area, the rows corresponding to address "Y", address "Z", address "Z-2", and address "Z+2" are managed in the ERH register, and the rows corresponding to address "X", address "Y", address "Z-2", and address "Z+2" are managed in the RH register. The row hammer refresh operation to be described with reference to FIGS. 27 and 28 is similar to that described with reference to FIGS. 25 and 26, and thus, additional description will be omitted to avoid redundancy.

Referring to FIG. 27, in operation S621, the memory device 200 may enter the ERH refresh mode.

In operation S622, the memory device 200 may designate a management aggressor row, based on information of a row managed in the ERH register. For example, as illustrated in FIG. 28, the memory device may designate the row corresponding to address "Z" as a management aggressor row.

In operation S623, the memory device 200 may perform the refresh operation on an extended victim row. For example, the memory device 200 may designate the row corresponding to address "Z-2" and the row corresponding to address "Z+2" as an extended victim row and may perform the refresh operation on the extended victim rows.

In operation S624, the memory device 200 may reset the ERH count data corresponding to the management aggressor row. For example, as illustrated in FIG. 28, the memory device 200 may reset both the ERH count cell of the count cell area and the ERH count data of the ERH register to "0" in association with the row corresponding to address "Z".

In operation S625, the memory device 200 may modify the ERH count data of the extended victim row.

For example, as illustrated in FIG. 28, the memory device 200 may increase the RH count data and the ERH count data of the row corresponding to address "Z-2" as much as "+1" and may increase the RH count data and the ERH count data of the row corresponding to address "Z+2" as much as "+1".

The activation of the extended victim row may be first performed to perform the refresh operation on the extended victim row. In other words, the access operation to the extended victim row is required for the extended victim row refresh operation. Accordingly, to manage the ERH count data and the RH count data being the number of times of access of the extended victim row more accurately, as illustrated in FIG. 28, the memory device 200 may modify the RH count data and the ERH count data of the extended victim row as much as "+1".

As described above, the memory device 200 may manage a row having relatively large ERH count data from among a plurality of rows by using the ERH register and may perform the extended row hammer refresh operation based on row information of the ERH register. Accordingly, the memory device 200 may manage the risk of occurrence of the row hammer phenomenon for each row to be an appropriate level or lower. This structural confirmation and operation may mean that the extended row hammer phenomenon is effectively prevented.

Because the memory device 200 considers the number of times of access in the extended victim row refresh operation, the memory device 200 may manage RH count data and/or ERH count data more accurately.

[Third Operation of Performing Extended Row Hammer Refresh Operation Based on ERH Register]

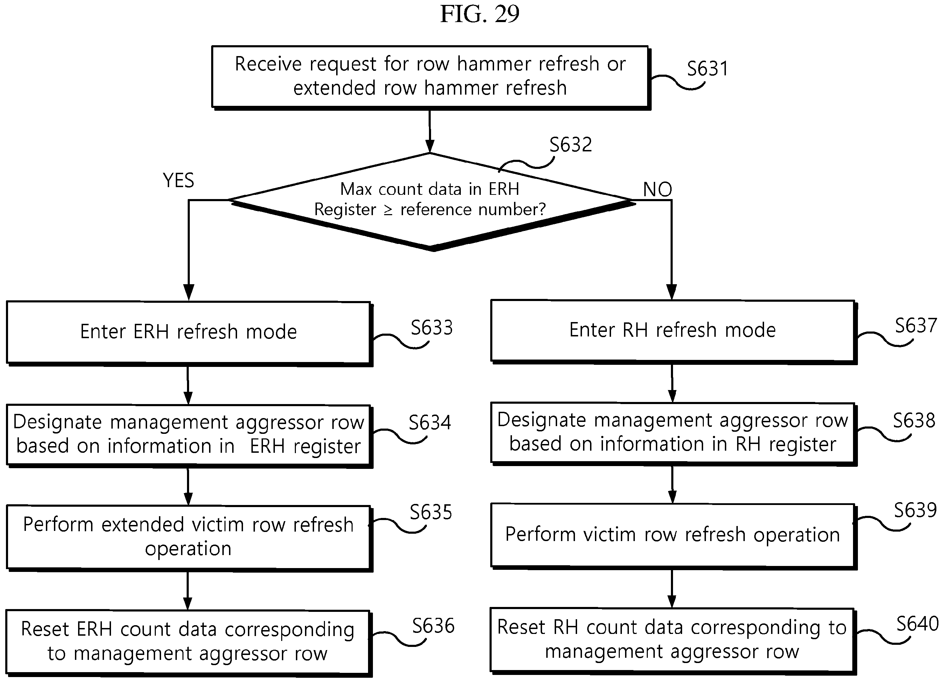

FIGS. 29 is a flowchart for describing an example of an operation of a memory device which selectively performs a row hammer refresh operation and an extended row hammer refresh operation, according to an embodiment. The row hammer refresh operation to be described with reference to FIG. 29 may correspond to operation S20 of FIG. 2, and the extended row hammer refresh operation to be described with reference to FIG. 29 may correspond to operation S40 of FIG. 3A. The row hammer refresh operation and the extended row hammer refresh operation to be described with reference to FIG. 29 are similar to those described with reference to FIGS. 25 to 28, and thus, additional description will be omitted to avoid redundancy.

Referring to FIG. 29, in operation S631, the memory device 200 may receive a row hammer refresh request or an extended row hammer refresh request. For example, the memory device 200 may receive the RFM command from a memory controller.

In operation S632, the memory device 200 may determine whether the maximum ERH count data managed in the ERH register is greater than or equal than to the reference number.

When the maximum ERH count data managed in the ERH register is greater than or equal to the reference number, the memory device 200 may enter the ERH refresh mode (operation S633). Afterwards, in operation S634, the memory device 200 may designate a management aggressor row, based on information of a row managed in the ERH register. In operation S635, the memory device 200 may perform the refresh operation on an extended victim row. In operation S636, the memory device 200 may reset the ERH count data corresponding to the management aggressor row.

When the maximum ERH count data managed in the ERH register is less than the reference number, the memory device 200 may enter the RH refresh mode (operation S637). Afterwards, in operation S638, the memory device 200 may designate a management aggressor row, based on information of a row managed in the RH register. In operation S639, the memory device 200 may perform the refresh operation on a victim row. In operation S640, the memory device 200 may reset the RH count data corresponding to the management aggressor row.

As described above, the memory device 200 may perform the extended row hammer refresh operation only when the maximum ERH count data managed in the ERH register is greater than or equal to the reference number. Accordingly, only when the disturbance due to the extended row hammer phenomenon is of a given level or higher, the extended row hammer refresh operation may be performed.

The memory device 200 may manage a row having relatively large RH count data and/or relatively large ERH count data from among a plurality of rows through the RH register and/or the ERH register and may perform the row hammer refresh operation and/or the extended row hammer refresh operation based on row information of the RH register and/or the ERH register. Accordingly, the memory device 200 may manage the risk of occurrence of the row hammer phenomenon and/or the risk of occurrence of the extended row hammer phenomenon for each row to be an appropriate level or lower. This structural configuration and operation may mean that the row hammer phenomenon and/or the extended row hammer phenomenon is effectively prevented.

### [Fourth Operation of Performing Extended Row Hammer Refresh Operation Based on ERH Register]

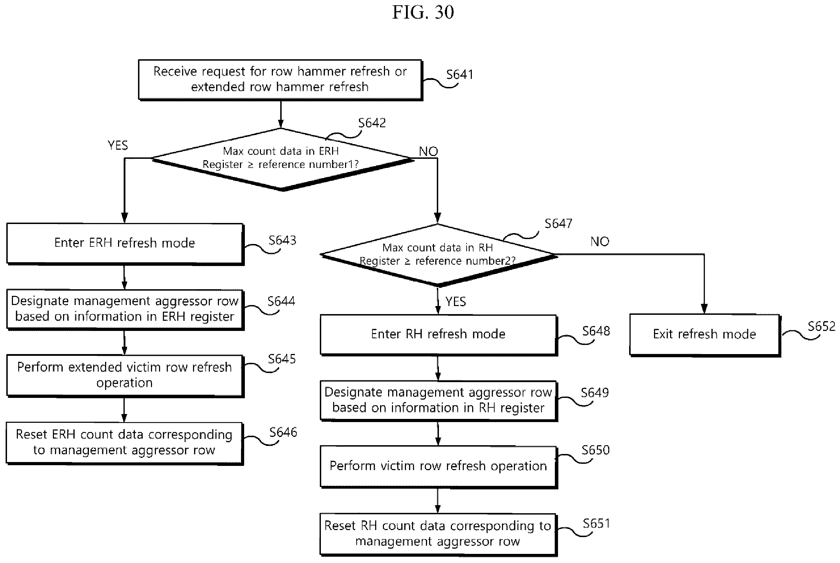

FIGS. 30 is a flowchart for describing an example of an operation of a memory device which selectively performs a row hammer refresh operation and an extended row hammer refresh operation, according to an embodiment. The row hammer refresh operation to be described with reference to FIG. 30 may correspond to operation S20 of FIG. 2, and the extended row hammer refresh operation to be described with reference to FIG. 30 may correspond to operation S40 of FIG. 3A. The row hammer refresh operation and the extended row hammer refresh operation to be described with reference to FIG. 30 are similar to those described with reference to FIGS. 29, and thus, additional description will be omitted to avoid redundancy.

Referring to FIG. 30, in operation S641, the memory device 200 may receive a row hammer refresh request or an extended row hammer refresh request.

In operation S642, the memory device 200 may determine whether the maximum ERH count data managed in the ERH register is greater than or equal than to the first reference number. In an embodiment, the first reference number may be a threshold number for entering the ERH refresh mode.

When the maximum ERH count data managed in the ERH register is greater than or equal to the first reference number, the memory device 200 may enter the ERH refresh mode (operation S643). Afterwards, in operation S644, the memory device 200 may designate a management aggressor row, based on information of a row managed in the ERH register. In operation S645, the memory device 200 may perform the refresh operation on an extended victim row. In operation S646, the memory device 200 may reset the ERH count data corresponding to the management aggressor row.

When the maximum ERH count data managed in the ERH register is less than the first reference number, the memory device 200 may determine whether the maximum RH count data managed in the RH register is greater than or equal to the second reference number (operation S647). In an embodiment, the second reference number may be a threshold number for entering the RH refresh mode.

When the maximum RH count data managed in the RH register is greater than or equal to the second reference number, the memory device 200 may enter the RH refresh mode (S648). Afterwards, in operation S649, the memory device 200 may designate a management aggressor row, based on information of a row managed in the RH register. In operation S650, the memory device 200 may perform the refresh operation on a victim row. In operation S651, the memory device 200 may reset the RH count data corresponding to the management aggressor row.

When the maximum RH count data managed in the RH register is less than the second reference number, the row hammer refresh operation and the extended row hammer refresh operation may be omitted and the refresh mode may be exited (operation S652).

According to an embodiment, the first reference number may greater than the second reference number. In general, when the same aggressor row is repeatedly accessed, the disturbance due to the row hammer phenomenon is greater than the disturbance due to the extended row hammer phenomenon. In other words, assuming that RH count data and ERH count data are identical, the probability that data of memory cells corresponding to a victim row will be lost may be higher than the probability that data of memory cells corresponding to an extended victim row will be lost. Accordingly, the victim row refresh operation may be performed more frequently compared to the extended victim row refresh operation. According to an embodiment, since the first reference number is greater than the second reference number, the victim row refresh operation may be performed frequently compared to the extended victim row refresh operation.

As described above, since the execution ratio of the victim row refresh operation to the extended victim row refresh operation is adjusted, the more effective row hammer refresh operation and/or the more effective extended row hammer refresh operation may be supported.

### [First Method of Performing Extended Row Hammer Refresh Operation by Using ERH Flag Data and Register Managing ERH Flag Data]

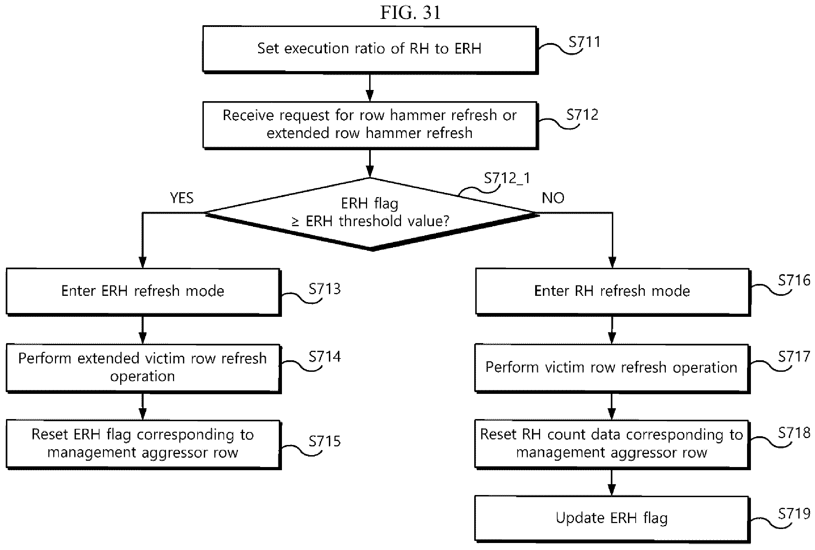

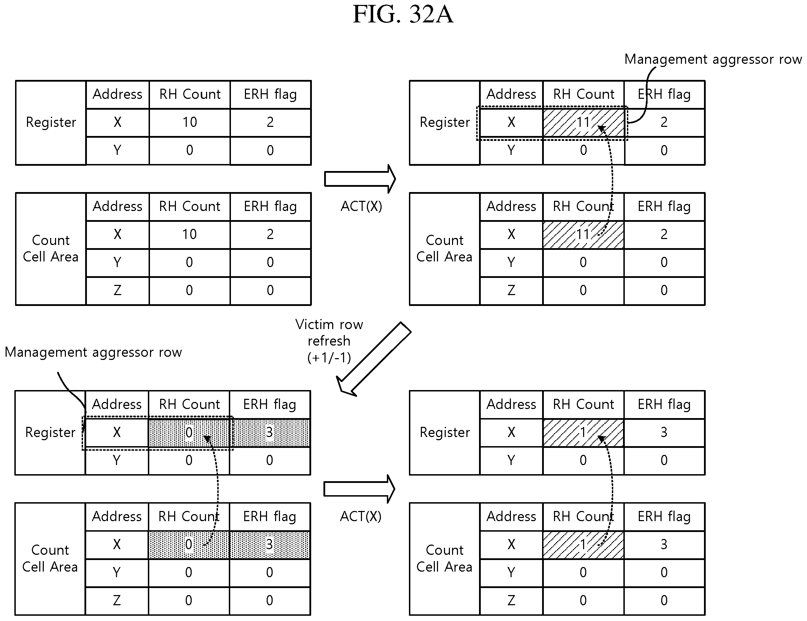

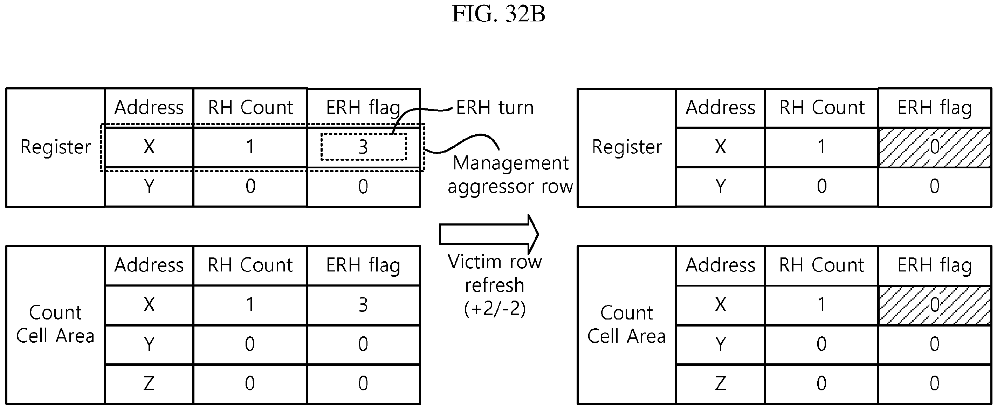

FIGS. 31, 32A, and 33B are diagrams for describing an example of an operation of a memory device which performs an extended row hammer refresh operation by using ERH flag data, according to an embodiment. In detail, a flowchart for performing the register update operation, the row hammer refresh operation, and/or the extended row hammer refresh operation according to an embodiment is illustrated in FIG. 31 as an example. An example in which a register managing ERH flag data is updated is illustrated in FIG. 32A. An example in which the extended row hammer refresh operation is performed based on ERH flag data of the register is illustrated in FIG. 32B. An operation method to be described with reference to FIGS. 31, 32A, and 32B may correspond to operation S50 and operation S60 of FIG. 3B.

For convenience of description, in FIGS. 32A and 32B, it is assumed that the register manages ERH flag data together with a row address and RH count data. Also, it is assumed that the execution ratio of the row hammer refresh operation to the extended row hammer refresh operation is 3:1.

Referring to FIG. 31, in operation S711, the memory device 200 may set the execution ratio of the row hammer refresh operation and the extended row hammer refresh operation.

Because the disturbance due to the row hammer phenomenon is greater than the disturbance due to the extended row hammer phenomenon, it is effective to perform the row hammer refresh operation more frequently than the extended row hammer refresh operation. For example, as illustrated in FIGS. 32A and 32B, the execution ratio may be set such that the extended row hammer refresh operation is performed once whenever the row hammer refresh operation is performed three times.

In operation S712, the memory device 200 may receive a request for row hammer refresh or extended row hammer refresh.

In operation S712_1, the memory device 200 may determine whether ERH flag data is greater than or equal to an ERH threshold value. For example, the memory device 200 may determine whether a turn at which the extended row hammer refresh operation is to be performed comes. For example, the memory device 200 may determine whether the turn at which the extended row hammer refresh operation is to be performed comes, by determining whether ERH flag data is greater than or equal to an ERH threshold value. In other words, the memory device 200 may determine whether an entry having ERH flag data greater than or equal to the ERH threshold value from among entries of the register exists. In an embodiment, the ERH threshold value may refer to a threshold value for entering the ERH refresh mode.

When the ERH flag data is less than the ERH threshold value, the memory device 200 may enter the RH refresh mode (operation S716). Afterwards, in operation S717, the memory device 200 may designate a management aggressor row based on information of a row managed in the register and may perform the refresh operation on a victim row. In operation S718, the memory device 200 may reset the RH count data corresponding to the management aggressor row. In operation S719, the memory device 200 may update the ERH flag data.

In an embodiment, the description will be given in detail with reference to FIG. 32A. It is assumed that an active command ACT(X) for a target row is first received and an address of the target row is "X".

In this case, the memory device 200 may modify RH count data of the count cell area through the RMW operation. For example, the memory device 200 may modify the RH count data of the row corresponding to address "X" from "10" to "11". Because the register already includes an entry associated with address "X", RH count data of the register corresponding to address "X" may be modified from "10" to "11".

Afterwards, it is assumed that, when the request for row hammer refresh or extended row hammer refresh is received, the ERH threshold value is "3".

In this case, because the ERH flag data (i.e., "2") is less than the ERH threshold value (i.e., "3"), the memory device 200 may enter the RH refresh mode. In this case, a row of address "X" having the maximum RH count data among pieces of RH count data of entries managed in the register may be designated as a management aggressor row, and a row of address "X-1" and a row of address "X+1" may be designated as victim rows. Afterwards, the refresh operations on the victim rows may be performed.

After the refresh operations on the victim rows performed, the memory device 200 may reset the RH count data of the count cell area and the RH count data of the register to "0" in association with the management aggressor row.

The memory device 200 may increase the ERH flag data being the number of times of execution of the row hammer refresh operation as much as "+1". For example, the memory device 200 may modify the ERH flag data corresponding to address "X" of the management aggressor row from "2" to "3". Accordingly, that the row hammer refresh operation on the row of address "X" is performed a total of three times may be marked through the ERH flag data.

Continuing to refer to FIG. 31, when the ERH flag data is greater than or equal to the ERH threshold value, the memory device may enter the ERH refresh mode (S713). Afterwards, in operation S714, the memory device 200 may designate a management aggressor row based on information of a row managed in the register and may perform the refresh operation on an extended victim row. In operation S715, the memory device 200 may reset the ERH flag data corresponding to the management aggressor row.

In an embodiment, the description will be given in detail with reference to FIG. 32B. It is assumed that, when the request for row hammer refresh or extended row hammer refresh is received, the ERH threshold value is "3".

In this case, because the ERH flag data (i.e., "3") is greater than or equal to the ERH threshold value (i.e., "3"), the memory device 200 may enter the ERH refresh mode. In this case, a row of address "X" having the maximum ERH count data among pieces of ERH count data of entries managed in the register may be designated as a management aggressor row, and a row of address "X-2" and a row of address "X+2" may be designated as extended victim rows. Afterwards, the refresh operations on the extended victim rows may be performed.

After the refresh operations on the extended victim rows are performed, the memory device 200 may reset the ERH flag data of the count cell area and the ERH flag data of the register to "0" in association with the management aggressor row.

As described above, the memory device 200 may designate a management aggressor row based on the ERH flag data and may perform the refresh operation on an extended victim row adjacent to the management aggressor row. Accordingly, the memory device 200 may manage the risk of occurrence of the row hammer phenomenon for each row to be an appropriate level or lower. This structural configuration and operation may mean that the extended row hammer phenomenon is effectively prevented.

Since the memory device 200 manages the number of times of execution of the row hammer refresh operation for each row through the ERH flag data, the memory device may easily set the execution ratio of the row hammer refresh operation to the extended row hammer refresh operation for each row.

### [Second Method of Performing Extended Row Hammer Refresh Operation by Using ERH Flag Data and Register Managing ERH Flag Data]

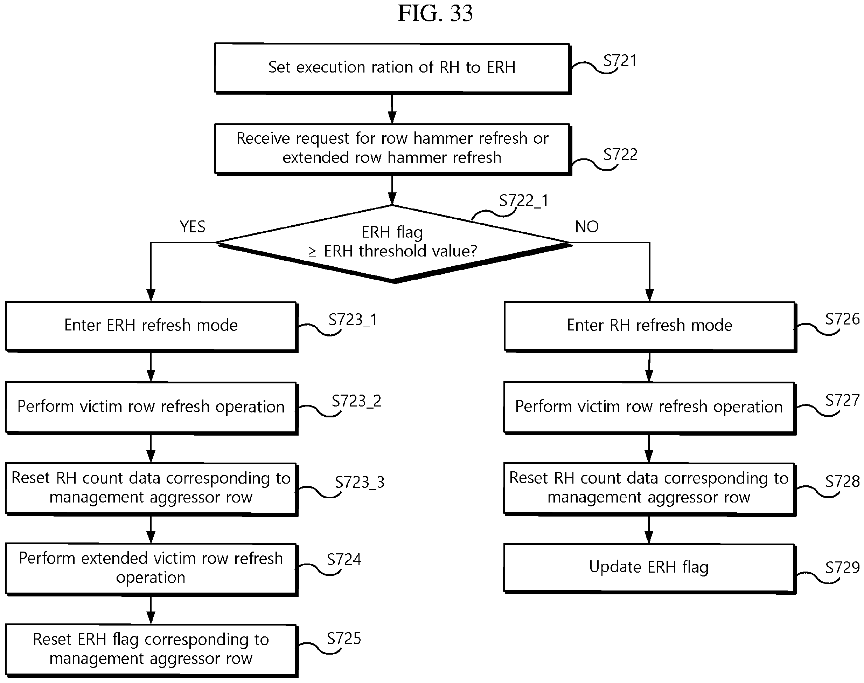

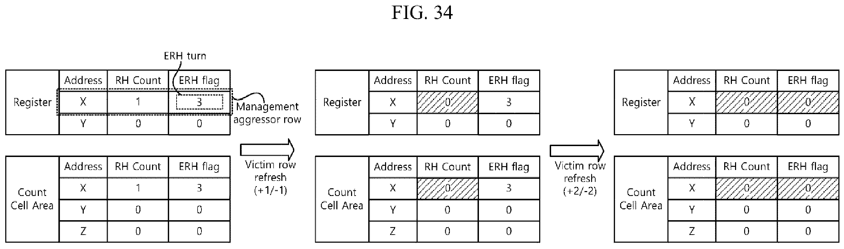

FIGS. 33 and 34 are diagrams for describing an example of an operation of a memory device which performs an extended row hammer refresh operation by using ERH flag data, according to an embodiment. In detail, a flowchart for performing the register update operation, the row hammer refresh operation, and/or the extended row hammer refresh operation according to an embodiment is illustrated in FIG. 33 as an example. An example in which the row hammer refresh operation and the extended row hammer refresh operation are performed based on ERH flag data of the register is illustrated in FIG. 34. An operation method to be described with reference to FIGS. 33 and 34 may correspond to operation S50 and operation S60 of FIG. 3B.

The operation method of the memory device to be described with reference to FIGS. 33 and 34 is similar to that of FIGS. 31 and 32, and thus, additional description will be omitted to avoid redundancy. Also, it is assumed that the execution ratio of the row hammer refresh operation to the extended row hammer refresh operation is 3:1.

Referring to FIG. 33, in operation S721, the memory device 200 may set the execution ratio of the row hammer refresh operation and the extended row hammer refresh operation.

In operation S722, the memory device 200 may receive a request for row hammer refresh or extended row hammer refresh.

In operation S722_1, the memory device 200 may determine whether an entry having ERH flag data greater than or equal to the ERH threshold value from among entries of the register exists.

When the ERH flag data is less than the ERH threshold value, the memory device 200 may enter the RH refresh mode (operation S726). Afterwards, in operation S727, the memory device 200 may designate a management aggressor row based on information of a row managed in the register and may perform the refresh operation on a victim row. In operation S728, the memory device 200 may reset the RH count data corresponding to the management aggressor row. In operation S729, the memory device 200 may update the ERH flag data.

When the ERH flag data is greater than or equal to the ERH threshold value, the memory device 200 may enter the ERH refresh mode. Unlike FIG. 31, in the ERH refresh mode to be described with reference to FIG. 32, the row hammer refresh operation and the extended row hammer refresh operation may be sequentially performed.

In detail, in operation S723_1, the memory device 200 may enter the ERH refresh mode. In operation S723_2, the memory device 200 may designate a management aggressor row based on the ERH flag data, may designate a victim row based on the management aggressor row, and may perform the refresh operation on the victim row. In operation S723_3, the memory device 200 may reset the RH count data corresponding to the management aggressor row. Afterwards, in operation S724, the memory device 200 may designate an extended victim row based on the management aggressor row and may perform the refresh operation on the extended victim row. In operation S725, the memory device 200 may reset the ERH flag data corresponding to the management aggressor row.

In an embodiment, the description will be given in detail with reference to FIG. 34. It is assumed that, when the request for row hammer refresh or extended row hammer refresh is received, the ERH threshold value is "3".

In this case, because the ERH flag data (i.e., "3") is greater than or equal to the ERH threshold value (i.e., "3"), the memory device 200 may enter the ERH refresh mode. In this case, a row of address "X" having the maximum ERH count data among pieces of ERH count data of entries managed in the register may be designated as a management aggressor row, a row of address "X-1" and a row of address "X+1" may be designated as victim rows, and a row of address "X-2" and a row of address "X+2" may be designated as extended victim rows.

Afterwards, the refresh operations on the victim rows may be performed. After the refresh operations on the victim rows performed, the memory device 200 may reset the RH count data of the count cell area and the RH count data of the register to "0" in association with the management aggressor row.

Afterwards, the refresh operations on the extended victim rows may be performed. After the refresh operations on the extended victim rows are performed, the memory device 200 may reset the ERH flag data of the count cell area and the ERH flag data of the register to "0" in association with the management aggressor row.

As described above, in the ERH refresh mode, the memory device 200 may designate a management aggressor row, a victim row, and an extended victim row based on ERH flag data and may perform the row hammer refresh operation and the extended row hammer refresh operation, respectively. Accordingly, the memory device 200 may manage the risk of occurrence of the row hammer phenomenon and the risk of occurrence of the extended row hammer phenomenon for each row to be an appropriate level or lower.

Since the memory device 200 manages the number of times of execution of the row hammer refresh operation for each row through the ERH flag data, the memory device 200 may easily set the execution ratio of the row hammer refresh operation to the extended row hammer refresh operation for each row.

### [Third Method of Performing Extended Row Hammer Refresh Operation by Using ERH Flag Data and Register Managing ERH Flag Data]

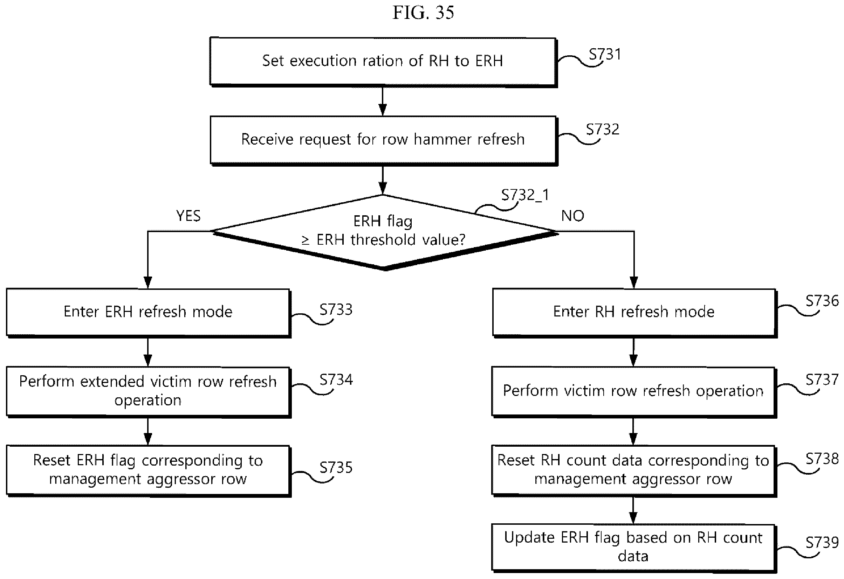

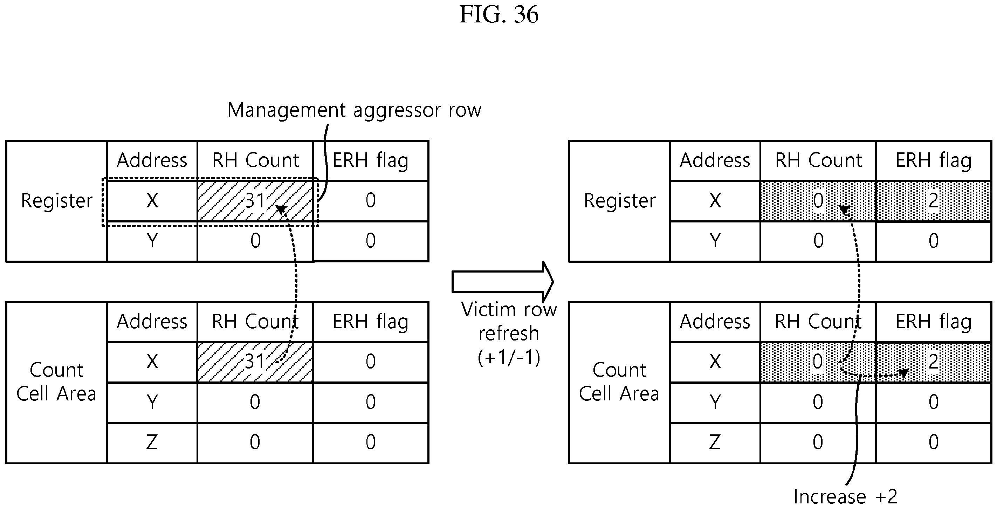

FIGS. 35 and 36 are diagrams for describing an example of an operation of a memory device which performs an extended row hammer refresh operation by using ERH flag data, according to an embodiment. In detail, a flowchart of the register update operation and the extended row hammer refresh operation according to an embodiment is illustrated in FIG. 35 as an example. An example in which ERH flag data are increased as much as "+k" based on RH count data is illustrated in FIG. 36. An operation method to be described with reference to FIGS. 35 and 36 may correspond to operation S50 and operation S60 of FIG. 3B.

The operation method of the memory device to be described with reference to FIGS. 33 and 34 is similar to that of FIGS. 31 and 32, and thus, additional description will be omitted to avoid redundancy.

In operation S731, the memory device 200 may set the execution ratio of the row hammer refresh operation to the extended row hammer refresh operation.

In operation S732, the memory device 200 may receive a request for row hammer refresh or extended row hammer refresh.

In operation S732_1, the memory device 200 may determine whether an entry having ERH flag data greater than or equal to the ERH threshold value from among entries of the register exists.

When the ERH flag data is less than the ERH threshold value, the memory device 200 may enter the RH refresh mode (operation S736). Afterwards, in operation S737, the memory device 200 may designate a management aggressor row based on information of a row managed in the register and may perform the refresh operation on a victim row. In operation S738, the memory device 200 may reset the RH count data corresponding to the management aggressor row.

Afterwards, in operation S739, the memory device 200 may update the ERH flag data based on the RH count data. For example, the memory device 200 may increase the ERH flag data as much as "+k" in consideration of the size of the RH count data. In other words, the memory device 200 may allocate a weight in consideration of the size of the RH count data and may determine the increment of the ERH flag data in consideration of the weight.

In an embodiment, the description will be given in detail with reference to FIG. 36. It is assumed that, when RH count data are larger than "30", a weight for the increment of ERH flag data is set. Also, it is assumed that, when the request for row hammer refresh or extended row hammer refresh is received, the ERH threshold value is "3".

In this case, because the ERH flag data (i.e., "2") is less than the ERH threshold value (i.e., "3"), the memory device 200 may enter the RH refresh mode. In this case, a row of address "X" having the maximum RH count data among pieces of RH count data of entries managed in the register may be designated as a management aggressor row, and the refresh operation on a victim row may be performed. After the refresh operation on the victim row is performed, the memory device 200 may reset the RH count data of the count cell area and the RH count data of the register to "0" in association with the management aggressor row.

Also, in this case, the memory device 200 may modify the ERH flag data being the number of times of execution of the row hammer refresh operation. Because the RH count data are larger than "30", the memory device 200 may increase the ERH flag data as much as "+2". As described above, as the increment of the ERH flag data is adjusted in consideration of the size of the RH count data, the risk of occurrence of the extended row hammer phenomenon may be managed more stably to be an appropriate level or lower.

When the ERH flag data is greater than or equal to the ERH threshold value, the memory device 200 may enter the ERH refresh mode (operation S733). Afterwards, in operation S734, the memory device 200 may designate a management aggressor row based on information of a row managed in the RH register and may perform the refresh operation on an extended victim row. In operation S735, the memory device 200 may reset the ERH flag data corresponding to the management aggressor row.

As described above, the memory device 200 may designate a management aggressor row based on the ERH flag data and may perform the refresh operation on an extended victim row adjacent to the management aggressor row. Accordingly, the memory device 200 may manage the risk of occurrence of the row hammer phenomenon for each row to be an appropriate level or lower. This structural configuration and operation may mean that the extended row hammer phenomenon is effectively prevented.

Since the increment of the ERH flag data is adjusted in consideration of the size of the RH count data, the risk of occurrence of the extended row hammer phenomenon may be managed more stably to be an appropriate level or lower.

Since the memory device 200 manages the number of times of execution of the row hammer refresh operation for each row through the ERH flag data, the memory device 200 may easily set the execution ratio of the row hammer refresh operation to the extended row hammer refresh operation for each row.

[Fourth Method of Performing Extended Row Hammer Refresh Operation by Using ERH Flag Data and Register Managing ERH Flag Data]

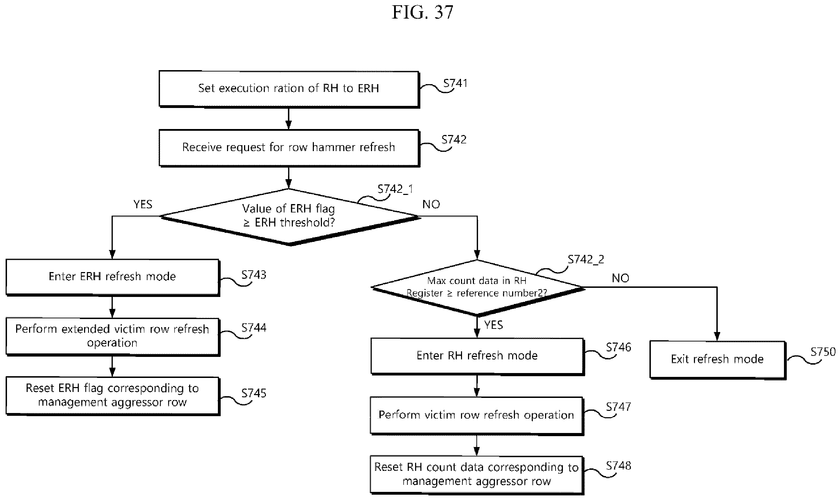

FIG. 37 is a flowchart for describing an example of an operation of a memory device which performs an extended row hammer refresh operation by using ERH flag data, according to an embodiment. An operation method to be described with reference to FIG. 37 may correspond to operation S50 and operation S60 of FIG. 3B.

The operation method of the memory device to be described with reference to FIG. 37 is similar to that of FIGS. 31 and 32, and thus, additional description will be omitted to avoid redundancy.

In operation S741, the memory device 200 may set the execution ratio of the row hammer refresh operation to the extended row hammer refresh operation.

In operation S742, the memory device 200 may receive a request for row hammer refresh or extended row hammer refresh.

In operation S742_1, the memory device 200 may determine whether an entry having ERH flag data greater than or equal to the ERH threshold value from among entries of the register exists.

When the ERH flag data is less than the ERH threshold value, the memory device 200 may determine whether the maximum RH count data among pieces of RH count data of entries of the RH register is greater than or equal to the reference number (S742_2).

When the maximum RH count data among the pieces of RH count data of the entries of the RH register is greater than or equal to the reference number, the memory device 200 may enter the RH refresh mode (S746). Afterwards, in operation S747, the memory device 200 may designate a management aggressor row based on information of a row managed in the register and may perform the refresh operation on a victim row. In operation S748, the memory device 200 may reset the RH count data corresponding to the management aggressor row.

When the maximum RH count data among the pieces of RH count data of the entries of the RH register is less than the reference number, the memory device 200 may omit the row hammer refresh operation and the extended row hammer refresh operation and exist the refresh mode (operation S750).

When the ERH flag data is greater than or equal to the ERH threshold value, the memory device 200 may enter the ERH refresh mode (operation S743). Afterwards, in operation S744, the memory device 200 may designate a management aggressor row based on information of a row managed in the RH register and may perform the refresh operation on an extended victim row. In operation S745, the memory device 200 may reset the ERH flag data corresponding to the management aggressor row.

As described above, the memory device 200 may designate a management aggressor row based on the ERH flag data and may perform the refresh operation on an extended victim row adjacent to the management aggressor row. Accordingly, the memory device 200 may manage the risk of occurrence of the row hammer phenomenon for each row to be an appropriate level or lower. This configuration and operation may mean that the extended row hammer phenomenon is effectively prevented.

Since the memory device 200 manages the number of times of execution of the row hammer refresh operation for each row through the ERH flag data, the memory device 200 may easily set the execution ratio of the row hammer refresh operation to the extended row hammer refresh operation for each row.

Since the row hammer refresh operation is performed only when RH count data is greater than or equal to the reference number, the row hammer refresh operation may be performed more efficiently.

### [Example of Setting ERH Flag Data]

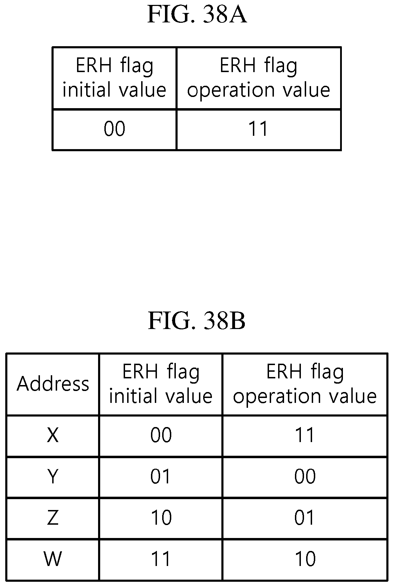

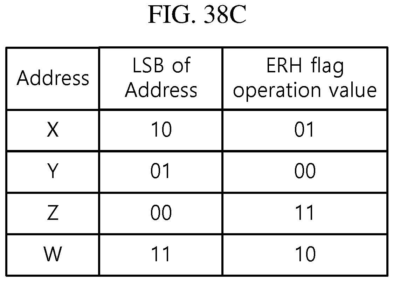

FIGS. 38A, 38B, and 38C are diagrams illustrating various embodiments, in which ERH flag data are set. For convenience of description, it is assumed that the execution ratio of the row hammer refresh operation to the extended row hammer refresh operation is 3:1 and ERH flag data are 2-bit data.

In an embodiment, as illustrated in FIG. 38A, an initial value of the ERH flag data may be set to a bit value of "00". As the row hammer refresh operation is repeated, the ERH flag data may increase to "00", "01", "10", and "11".

In an embodiment, bit value "00" of the ERH flag data may mean that the row hammer refresh operation is not performed; bit value "01" of the ERH flag data may mean that the row hammer refresh operation is performed once; bit value "10" of the ERH flag data may mean that the row hammer refresh operation is performed two times; and, bit value "11" of the ERH flag data may mean that the row hammer refresh operation is performed three times.

In an embodiment, an ERH flag operation value may be set to "11". In an embodiment, the ERH flag operation value may correspond to the ERH threshold value described above. According to the above description, the extended row hammer refresh operation may be performed after the row hammer refresh operation is performed three times.

In an embodiment, as illustrated in FIG. 38B, initial values of ERH flag data respectively corresponding to rows may be differently set.

For example, an initial value of ERH flag data of a row whose address is "X" may be set to "00". In this case, an operation value of the ERH flag data of the row whose address is "X" may be set to "11".

For another example, an initial value of ERH flag data of a row whose address is "Y" may be set to "01". In this case, an operation value of the ERH flag data of the row whose address is "Y" may be set to "00".

For another example, an initial value of ERH flag data of a row whose address is "Z" may be set to "10". In this case, an operation value of the ERH flag data of the row whose address is "Z" may be set to "01".

For another example, an initial value of ERH flag data of a row whose address is "W" may be set to "11". In this case, an operation value of the ERH flag data of the row whose address is "W" may be set to "10".

In an embodiment, as illustrated in FIG. 38C, the initial value of the ERH flag data of each row may be set, for example, by using least significant bits (LSBs) of the corresponding row.

For example, when the LSBs of the row whose address are "10", an initial value of ERH flag data of the corresponding row may be identically set to "10". In this case, an operation value of the ERH flag data of the row whose address is "X" may be set to "01". According to the above description, the extended row hammer refresh operation may be performed after the row hammer refresh operation is performed three times.

Likewise, when the LSBs of the row whose address are "Y", "Z", or "W" are "01", "00", or "11", an initial value of ERH flag data of the corresponding row may be set to "00", "11", or "10".

As described above, as initial values and operation values of pieces of ERH flag data of rows are differently set, ERH flag data may be protected more stably from an external attack.

A memory device according to various embodiments may effectively prevent a row hammer phenomenon and an extended row hammer phenomenon.

While various embodiments have been described with reference to the drawings, it will be apparent to those of ordinary skill in the art that various changes and modifications may be made thereto without departing from the scope of the present disclosure as set forth in the following claims.

## Claims

1. A memory device comprising:
at least one bank including a plurality of memory cells,
wherein the at least one bank includes:
a plurality of rows arranged in a row direction;
a plurality of count cells, each configured to store row hammer count data associated with a number of times a corresponding row of the plurality of rows is accessed; and
a plurality of extended count cells, each configured to store information about at least one of extended row hammer count data associated with the number of times the corresponding row of the plurality of rows is accessed or a number of times a row hammer refresh operation is executed on the corresponding row of the plurality of rows.

2. The memory device of claim 1, wherein the row hammer count data and the extended row hammer count data are reset at different time points.

3. The memory device of claim 1 or 2, further comprising:
at least one register that corresponds to the at least one bank,
wherein the at least one register stores at least one of the row hammer count data associated with at least one row among the plurality of rows, the extended row hammer count data associated with the at least one row among the plurality of rows, or the number of times the row hammer refresh operation associated with the at least one row among the plurality of rows is executed.

4. The memory device of claim 3, wherein the plurality of extended count cells are configured to store the extended row hammer count data, and
wherein the at least one register includes:
a first register configured to store the row hammer count data of the at least one row among the plurality of rows; and
a second register configured to store the extended row hammer count data of the at least one row among the plurality of rows.

5. The memory device of claim 4, further comprising:
a row hammer management circuit configured to manage the row hammer count data of the first register and the extended row hammer count data of the second register,
wherein the row hammer management circuit is configured to:
update the first register with an address and modified row hammer count data, which correspond to an access-requested target row; and
update the second register with an address and modified extended row hammer count data, which correspond to a target row.

6. The memory device of claim 5, wherein the row hammer management circuit updates the second register, based on a comparison result of the modified extended row hammer count data corresponding to the target row with the extended row hammer count data stored in the second register.

7. The memory device of claim 6, wherein, when the modified extended row hammer count data corresponding to the target row is greater than a minimum extended row hammer count data among extended row hammer count data stored in the second register, the row hammer management circuit replaces an entry of the second register corresponding to the minimum extended row hammer count data with the address and the modified extended row hammer count data of the target row.

8. The memory device of claim 5 or 6, wherein, when the address corresponding to the target row coincides with the address stored in the second register, the row hammer management circuit replaces extended row hammer count data previously stored in the second register and corresponding to the target row with the modified extended row hammer count data corresponding to the target row.

9. The memory device of any one of claims 5 to 8, wherein, when the modified extended row hammer count data corresponding to the target row is less than a first reference number, the row hammer management circuit postpones the update of the second register until the modified extended row hammer count data corresponding to the target row is greater than or equal to the first reference number.

10. The memory device of claim 9, wherein, when the row hammer count data corresponding to the target row is less than a second reference number, the row hammer management circuit postpones the update of the first register until the row hammer count data corresponding to the target row is greater than or equal to the second reference number, and
wherein the first reference number is larger than the second reference number.

11. The memory device of any one of claims 4 to 10, wherein an extended row hammer refresh operation is performed based on an address and the extended row hammer count data of the at least one row stored in the second register.

12. The memory device of claim 11, wherein a row having a maximum extended row hammer count data from among a plurality of rows managed in the second register is designated as a management aggressor row.

13. The memory device of claim 11 or 12, wherein the extended row hammer refresh operation is performed when a maximum extended row hammer count data among the extended row hammer count data of the at least one row managed in the second register is greater than or equal to a third reference number.

14. The memory device of any one of claims 3 to 13, wherein each of the plurality of extended count cells stores a number of times the row hammer refresh operation is executed on the corresponding row, and
wherein the at least one register stores the row hammer count data and the number of times the row hammer refresh operation is executed on at least one row among the plurality of rows.

15. The memory device of claim 14, further comprising:
a row hammer management circuit configured to manage the row hammer count data and the number of times the row hammer refresh operation is executed, and
wherein the row hammer management circuit is configured to:
set an execution ratio, the execution ratio being a ratio of the row hammer refresh operation to the extended row hammer refresh operation; and
set a threshold value for a number of times the extended row hammer refresh operation is executed based on the execution ratio.
